# EUROPEAN PATENT APPLICATION

(11) **EP 4 350 932 A1**
(43) Date of publication of application: **10.04.2024**
(21) Application number: 22810316.4
(22) Date of filing: 29.04.2022
(51) Int. Cl.: H02J 7/00, F16M 11/04

(54) **CHARGING APPARATUS AND APPLICATION THEREOF**

(30) Priority: 28.05.2021 CN 202110599058; 28.05.2021 CN 202110597865; 28.05.2021 CN 202110599307; 28.05.2021 CN 202110596482; 28.05.2021 CN 202110592753; 28.05.2021 CN 202121189130 U; 28.05.2021 CN 202110594850; 28.05.2021 CN 202121190271 U; 28.05.2021 CN 202110592705; 28.05.2021 CN 202121184354 U; 28.05.2021 CN 202110599309; 28.05.2021 CN 202121186579 U; 28.05.2021 CN 202110598795; 28.05.2021 CN 202121190161 U; 28.05.2021 CN 202110599308; 28.05.2021 CN 202121186577 U; 28.05.2021 CN 202110594817; 28.05.2021 CN 202121189223 U; 28.05.2021 CN 202110594820
(71) Applicant: Globe (Jiangsu) Co., Ltd., Changzhou, Jiangsu 213023 (CN)
(72) Inventor: HUO, Xiaohui, Hangzhou, Jiangsu 213023 (CN); LU, Chuntao, Hangzhou, Jiangsu 213023 (CN); YAN, An, Hangzhou, Jiangsu 213023 (CN); LI, Zhiyuan, Hangzhou, Jiangsu 213023 (CN); WANG, Doushi, Hangzhou, Jiangsu 213023 (CN); ZHU, Yanqiang, Hangzhou, Jiangsu 213023 (CN); ZHU, Yanliang, Hangzhou, Jiangsu 213023 (CN)
(74) Representative: Bergenstråhle & Partners AB
(86) International application number: PCT/CN2022/090616
(87) International publication number: WO 2022/247587

(57) **Abstract**

A charging device and an application thereof are provided. The charging device includes a housing, defining a receiving cavity; a circuit board, arranged in the receiving cavity; an input part, provided on the housing and configured for connection to an external power supply; and a plurality of output parts, provided on the housing, the input part and the output part being electrically connected via the circuit board. Each of the output parts includes at least one terminal, and the terminal is arranged in the receiving cavity and passes through the housing to a surface of the housing. The charging device can be applied to charge a wide range of electronic devices.

## Description

### CROSS REFERENCE TO RELATED DISCLOSURE

The disclosure is a national phase of PCT disclosure No. PCT/CN2022/090616 filed on April 29, 2022, which claims the benefit of CN202110592705.7 filed on May 28, 2021, CN202110592753.6 filed on May 28, 2021, CN202110594817.6 filed on May 28, 2021, CN202110594820.8 filed on May 28, 2021, CN202110594850.9 filed on May 28, 2021, CN202110596482.1 filed on May 28, 2021, CN202110597865.0 filed on May 28, 2021, CN202110598795.0 filed on May 28, 2021, CN202110599058.2 filed on May 28, 2021, CN202110599307.8 filed on May 28, 2021, CN202110599308.2 filed on May 28, 2021, CN202110599309.7 filed on May 28, 2021, CN202121184354.8 filed on May 28, 2021, CN202121186577.8 filed on May 28, 2021, CN202121186579.7 filed on May 28, 2021, CN202121189130.6filed on May 28, 2021, CN202121189223.9 filed on May 28, 2021, CN202121190161.3 filed on May 28, 2021, and CN202121190271.X filed on May 28, 2021. All the above are hereby incorporated by reference for all purposes.

### TECHNICAL FIELD

The disclosure relates to a technical field of charging technology, and particularly relates to a charging device and its application.

### BACKGROUND

The charging device is a common energy conversion device. The charging device can convert alternating current into the required specific voltage and current to charge electronic devices. Other charging devices can also convert light energy into chemical energy, store it inside the charging device, and convert chemical energy into electrical energy for use by electronic devices when the electronic devices need to be charged.

The output specifications of conventional charging devices are relatively single, and the conventional charging devices can only provide power for a single device at a time. When multiple devices need to be charged, the electronic devices need to be charged in sequence, which takes a long time and has low efficiency. Moreover, the conventional terminals are exposed to the air and are easily affected by the external environment which may cause short circuits.

### SUMMARY

A purpose of the disclosure is to provide a charging device. Through the charging device of some exemplary embodiments of the disclosure, a variety of charging methods and charging scenarios are provided to charge a variety of electronic devices.

In order to solve the above technical problems, some exemplary embodiments are implemented through the following technical solutions.

Some exemplary embodiments of the disclosure provide a charging device, and the charging device includes a housing, a circuit board, an input part and a plurality of output parts.

The housing defines a receiving cavity.

The circuit board is arranged in the receiving cavity.

The input part is provided on the housing and configured for connection to an external power supply.

The plurality of output parts is provided on the housing, the input part and the output part are electrically connected via the circuit board.

Each of the output parts includes at least one terminal, and the terminal is arranged in the receiving cavity and passes through the housing to a surface of the housing.

In some exemplary embodiments, the output part includes a first output part, a second output part and a third output part, and the first output part, the second output part and the third output part are of different types.

In some exemplary embodiments, the charging device includes a receiving groove, and the receiving groove is provided on the housing to accommodate an electronic device.

In some exemplary embodiments, the charging device further includes an output protection device, and the output protection device is arranged on one of the terminals and allows the output protection device to cover and expose the terminal.

In some exemplary embodiments, the output protection device includes a fixing part and a sliding part.

The fixing part is arranged in the housing of the charging device and is fixedly connected to the housing.

The sliding part is arranged between the fixing part and the housing, and the sliding part is capable of sliding between a first position and a second position.

When the sliding part is in the first position, the sliding part is configured to cover the output part of the charging device, and when the sliding part is in the second position, the output part of the charging device is at least partially exposed to the sliding part.

In some exemplary embodiments, the sliding part is provided with a sliding protrusion, the sliding protrusion is located on the sliding part proximate to an opening in the housing, the sliding protrusion passes through the opening and allows the sliding protrusion to slide in the opening.

In some exemplary embodiments, a locking structure is provided on one side of the housing, and the locking structure includes a first locking unit and a second locking unit.

The first locking unit is arranged at a bottom of the charging device.

The second locking unit is arranged on a top of a fixed base, and the second locking unit is detachably connected to the first locking unit.

In some exemplary embodiments, the first locking unit includes a plurality of sliding ribs and a locking groove.

The plurality of sliding ribs is arranged on one side of the first locking unit, and the plurality of sliding ribs is parallel to each other.

The locking groove is provided on one side of the plurality of sliding ribs, and the locking groove is arranged on the side surface of the first locking unit where the first locking unit is connected to the bottom of the charging device.

In some exemplary embodiments, the second locking unit includes a plurality of matching sliding ribs and a locking member.

The plurality of matching sliding ribs is parallel to each other and capable of being interspersed and fitted with the plurality of sliding ribs.

The locking member is arranged in the second locking unit and capable of be inserted into or disengaged from the locking groove.

When the locking member is inserted into the locking groove, the first locking unit and the second locking unit are locked.

When the locking member is disengaged from the locking groove, the first locking unit and the second locking unit are unlocked.

In some exemplary embodiments, a wall-mounted locking device is also provided on one side of the housing, and the wall-mounted locking device includes a backboard body and a backboard mating part.

The backboard body is arranged on a vertical wall.

The backboard mating part is provided on the housing, and the backboard mating part is detachably connected to the backboard body.

In some exemplary embodiments, the backboard body includes a slideway and a clamping member.

The slideway is provided on the backboard body; and

The clamping member is arranged on the backboard body.

In some exemplary embodiments, the backboard mating part includes a matching slideway and a clamping member mating structure.

The matching slideway is provided on the backboard mating part and cooperates with the slideway to allow the slideway to slide within the matching slideway.

The clamping member mating structure is provided on the backboard mating part and fits with the locking structure.

In some exemplary embodiments, the mating slideway includes a first matching slideway and a second matching slideway, the first matching slideway and the second matching slideway are symmetrically arranged on the backboard mating part, the matching slideway is fitted with the slideway, and the slideway is capable of sliding in the matching slideway.

Some exemplary embodiments of the disclosure provide a charging assembly, and the charging assembly includes a charging device and an electronic device.

The Charging device includes a housing, a circuit board, an input part and a plurality of output parts.

The housing defines a receiving cavity.

The circuit board is arranged in the receiving cavity.

The input part is provided on the housing and configured for connection to an external power supply.

The plurality of output parts is provided on the housing, the input part and the output part are electrically connected through the circuit board.

Each of the output parts includes at least one terminal, and the terminal is arranged in the receiving cavity and passes through the housing to a surface of the housing.

The electronic device is electrically connected to the terminal of the charging device.

In some exemplary embodiments, the electronic device is a battery pack, the battery pack is fixed on the housing, and the battery pack is provided with a plurality of ports, the ports are coupled with the terminals.

In some exemplary embodiments, the electronic device is a vacuum cleaner, the vacuum cleaner is fixed on the housing, the vacuum cleaner is fixed on the housing, the vacuum cleaner is provided with a charging port, and the charging port is coupled with one of the terminals.

Some exemplary embodiments of the disclosure provide a charging man-machine interaction system, the system includes a charging module, a detection module and a display module.

The charging module includes a housing, a circuit board, an input part and a plurality of output parts.

The housing defines a receiving cavity.

The circuit board is arranged in the receiving cavity.

The input part is provided on the housing and configured for connection to an external power supply.

The plurality of output parts is provided on the housing, the input part and the output part are electrically connected through the circuit board.

Each of the output parts includes at least one terminal, and the terminal is arranged in the receiving cavity and passes through the housing to a surface of the housing.

The detection module is connected to the charging module for obtaining charging information, and the charging information at least includes one or a combination of battery capacity information, charging real-time status information, and charging prediction information.

An input end of the display module is connected to an output end of the detection module, and the charging information of one or more connected devices to be charged is displayed through the display module.

Some exemplary embodiments of the disclosure provide a charging man-machine interaction display system, and the system includes a detection module and a display module.

The detection module obtains charging information, and the charging information includes at least one or a combination of battery capacity information, charging real-time status information, and charging prediction information.

An input end of the display module is connected to an output end of the detection module, and the charging information of one or more connected devices to be charged is displayed through the display module.

The disclosure also provides a method of charging man-machine interaction, and the method including:
obtaining charging information, the charging information comprising at least one of battery capacity information, charging real-time status information, and charging prediction information; and
displaying the charging information of one or more connected devices to be charged.

Some exemplary embodiments of the disclosure provide a method of intelligent allocation of charging power, and the method includes:
obtaining a working state of each load which is connected to multi-output port in a circuit for intelligent allocation of charging power;
determining at least one set of to-be-complementary output ports to be complemented by charging power according to the working state; and
controlling the set of to-be-complementary output ports to be complemented by charging power.

Some exemplary embodiments of the disclosure provide a method of charging energy distribution, and the method includes:
obtaining a charging state of one or more charged devices, each charged device being connected to a same circuit for charging energy distribution; and
if there is a target charged device, controlling the circuit for charging energy distribution to charge the target charged device with the maximum output charging power, and suspend charging of remaining charged devices, wherein the target charged device is one of the charged devices with a charging state reaching a preset charging state.

As mentioned above, using a charging device of embodiments of the disclosure, by arranging multiple terminals, the charging device has multiple voltage outputs; by arranging wall-mounted locking device and locking structure on different sides of the housing, the charging device is provided with multiple charging scenarios. The charging device provided by embodiments of the disclosure provides a variety of charging methods and charging scenarios to charge a variety of electronic devices.

Of course, implementing any product of the disclosure does not necessarily require achieving all the above-mentioned advantages at the same time.

### BRIEF DESCRIPTION OF THE DRAWINGS

In order to more clearly illustrate the technical solutions of the embodiments of the disclosure, the drawings required for describing the embodiments will be briefly introduced below. Obviously, the drawings in the following description are only some embodiments of the disclosure. For those of ordinary skill in the art, other drawings can also be obtained based on these drawings without exerting creative efforts.
FIG. 1 is an application scenario diagram of a charging device.
FIG. 2 is a perspective view of a charging device.
FIG. 3 is a perspective view of part of a charging device.
FIG. 4 is an exploded view of a housing.
FIG. 5 is a structural diagram of a first housing.
FIG. 6 is a structural diagram of an auxiliary circuit board according to an embodiment of the disclosure.
FIG. 7 is a partial internal structural diagram of a charging device.
FIG. 8 is a schematic perspective view of a charging device.
FIG. 9 is a front view of a charging device.
FIG. 10 is a schematic diagram of a structure and installation of an output protection device.
FIG. 11 is a schematic structural diagram of an output protection device.
FIG. 12 is a schematic structural diagram of a fixing part in FIG. 11.
FIG. 13 is a schematic structural diagram of the output protection device in FIG. 11 with a fixing part removed.
Fig. 14 is a schematic structural diagram of a sliding part in Fig. 13.
Fig. 15 is a schematic structural diagram of a first housing in Fig. 13.
FIG. 16 is a schematic structural diagram of the first housing in FIG. 13 from another angle.
FIG. 17 is a structural diagram of a third housing.
FIG. 18 is a structural view of the third housing from another angle.
FIG. 19 is a schematic structural diagram of a backboard body in the wall-mounted locking device according to an embodiment of the disclosure.
FIG. 20 is a second schematic structural diagram of the backboard body in the wall-mounted locking device from another angle according to an embodiment of the disclosure.
FIG. 21 is a third schematic structural diagram of the backboard body in the wall-mounted locking device from another angle according to an embodiment of the disclosure.
FIG. 22 is a schematic structural diagram of the backboard mating part in the wall-mounted locking device according to an embodiment of the disclosure.
FIG. 23 is a schematic structural diagram of a charging device provided with a backboard mating part.
FIG. 24 is a schematic structural diagram of a charging device provided with a backboard mating part from another angle.
FIG. 25 is a schematic diagram of a locking structure of the charging device according to an embodiment of the disclosure.
FIG. 26 is a schematic structural diagram of a first locking unit in the charging device according to an embodiment of the disclosure.
FIG. 27 is a schematic bottom view of a structure of the first locking unit in the charging device according to an embodiment of the disclosure.
FIG. 28 is a schematic structural diagram of a second locking unit in the fixed base according to an embodiment of the disclosure.
FIG. 29 is a schematic structural diagram of a locking base in FIG. 27.
FIG. 30 is a schematic structural diagram of a locking cover in FIG. 27.
FIG. 31 is a schematic structural diagram of a locking member according to an embodiment of the disclosure.
FIG. 32 is a schematic structural diagram of a locking structure in a locked state according to an embodiment of the disclosure.
FIG. 33 is a schematic structural diagram of a locking structure in an unlocked state according to an embodiment of the disclosure.
FIG. 34 is a scene diagram of using a first terminal and/or a second terminal to charge a battery pack.
FIG. 35 shows a scene diagram of using an output part to charge a battery pack.
FIG. 36 is diagram showing positions of terminals of a battery pack.
FIG. 37 is a structural diagram of a battery pack.
FIG. 38 is a first dimensional diagram of a sliding groove of a battery pack.
FIG. 39 is a second dimensional diagram of a sliding groove of a battery pack.
FIG. 40 is a first dimensional diagram of a guide rail of a charging device.
FIG. 41 is a second dimensional diagram of a guide rail of a charging device.
FIG. 42 is a structural diagram of a vacuum cleaner.
FIG. 43 is a schematic diagram of information displayed in a charging man-machine interaction system according to an embodiment of the disclosure.
FIG. 44 is a schematic principle diagram of a charging man-machine interaction system according to an embodiment of the disclosure.
FIG. 45 is a schematic block diagram showing workflows of a method of charging man-machine interaction according to an embodiment of the disclosure.
FIG. 46 is a schematic flowchart of a method of charging man-machine interaction according to an embodiment of the disclosure.
FIG. 47 is a schematic structural diagram of a drive control circuit according to an embodiment of the disclosure.
FIG. 48 is a schematic structural diagram of another drive control circuit according to an embodiment of the disclosure.
FIG. 49 is a schematic flowchart of a drive control method according to an embodiment of the disclosure.
FIG. 50 is a schematic diagram of the signal flow of a drive control method according to an embodiment of the disclosure.
FIG. 51 is a schematic structural diagram of a drive control device according to an embodiment of the disclosure.
FIG. 52 is a schematic structural diagram of a rechargeable battery according to an embodiment of the disclosure.
FIG. 53 is a schematic structural diagram of a charging control circuit according to an embodiment of the disclosure.
FIG. 54 is a schematic diagram of charging an electrical equipment according to an embodiment of the disclosure.
FIG. 55 is a schematic flowchart of a charging control method according to an embodiment of the disclosure.
FIG. 56 is a schematic diagram of charging a rechargeable battery according to an embodiment of the disclosure.
FIG. 57 is a schematic structural diagram of a circuit for intelligent allocation of charging power according to an embodiment of the disclosure.
FIG. 58 is a second structural schematic diagram of a circuit for intelligent allocation of charging power according to an embodiment of the disclosure.
FIG. 59 is a third structural schematic diagram of a circuit for intelligent allocation of charging power according to an embodiment of the disclosure.
FIG. 60 is a schematic diagram of a working principle of a circuit for intelligent allocation of charging power according to an embodiment of the disclosure.
FIG. 61 is a schematic flowchart of a method of intelligent allocation of charging power according to an embodiment of the disclosure.
FIG. 62 is a schematic flow chart of a control method of a circuit for intelligent allocation of charging power according to an embodiment of the disclosure.
FIG. 63 is a schematic structural diagram of a circuit for charging energy distribution according to an embodiment of the disclosure.
FIG. 64 is another structural schematic diagram of a circuit for charging energy distribution according to an embodiment of the disclosure.
FIG. 65 is a schematic diagram of a working principle of a circuit for charging energy distribution according to an embodiment of the disclosure.
FIG. 66 is yet another structural schematic diagram of a circuit for charging energy distribution according to an embodiment of the disclosure.
FIG. 67 is a schematic flow chart of a method of charging energy distribution according to an embodiment of the disclosure.
FIG. 68 is a schematic flow chart of a control method of a circuit for charging energy distribution according to an embodiment of the disclosure.

### DETAILED DESCRIPTION

The technical solutions in the embodiments of the disclosure will be clearly and completely described below with reference to the accompanying drawings in the embodiments of the disclosure. Obviously, the described embodiments are only some of the embodiments of the disclosure, rather than all of the embodiments. Based on the embodiments in the disclosure, all other embodiments obtained by those of ordinary skill in the art without making creative efforts fall within the scope of protection of the disclosure.

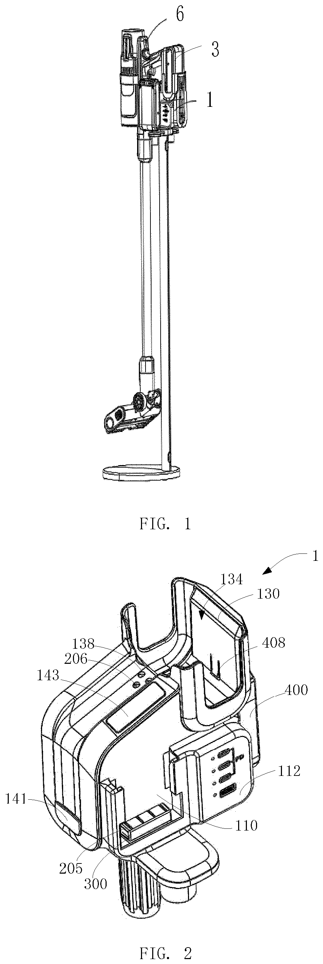

Please refer to FIG. 1. The charging device 1 provided by embodiments of the disclosure can realize voltage conversion and convert alternating current into a required specific voltage. A conventional charging device 1 can only output a single voltage, and can only power one specific electronic device at the same time. The charging device 1 provided in the disclosure can output multiple voltages at the same time. It can not only charge a specific vacuum cleaner 6 and battery pack 3, but also can charge more common electronic devices, such as tablets and computers.

Referring to FIGS. 1 to 7, a charging device 1 provided by the disclosure includes a housing 10 and a circuit board. The circuit board is arranged inside the receiving cavity formed by the housing 10. An output end/input end of the circuit board is provided with multiple terminals, and the housing 10 is provided with multiple ports correspondingly to the terminals. The terminals pass through the ports on the housing 10 to the outside of the housing 10. When the electronic device needs to be charged/discharged, a port (charging port/discharging port) of the electronic device is electrically connected to the terminal of the circuit board, to realize charging/discharging the electronic device or charging the circuit board. Electronic devices in the disclosure include but are not limited to vacuum cleaners 6, battery packs 3, mobile phones, tablets, computers and other electronic devices.

Referring to FIGS. 2 to 4, in an embodiment of the disclosure, the housing 10 includes a first housing 110, a second housing 120 and a third housing 130. The first housing 110 and the second housing 120 are buckled together to form a receiving cavity with a first opening 101 on one side. The third housing 130 is engaged with the first opening 101, and then the first housing 110, the second housing 120 and the third housing 130 form a closed receiving cavity, and a receiving groove 134 is also provided on the third housing 130 for placing electronic devices or battery packs. In an embodiment of the disclosure, the housing 10 is made from non-conductive material, such as hard plastic, but it can also be made from other non-conductive materials. In a specific embodiment of the disclosure, the housing 10 is made from acrylonitrile-butadiene-styrene plastic (ABS), which has excellent impact resistance, heat resistance, low temperature resistance, chemical resistance and excellent electrical properties, etc. It is easy processing its products are dimensionally stable and have good surface gloss. It is easy to paint, color, and secondary processing. For the housing 10 made from this material, a weight of the first housing 110 is, for example, 80 to 85 grams, in one embodiment, the weight of the first housing 110 is 85 grams. A weight of the second housing 120 is, for example, 70 to 75 grams, in one embodiment, the weight of the second housing 120 is 73 grams. A weight of the third housing 130 is, for example, 120 to 125 grams, in one embodiment, the weight of the third housing 130 is 120 grams.

Please refer to FIGS. 2 to 4. In an embodiment of the disclosure, the housing 10 substantially has a quadrangular prism structure with a notch 102, and a receiving groove 134 is provided on the notch 102. The quadrangular prism structure is, for example, in the form of a right-angled trapezoid, and the notch 102 is located at the junction of a longer bottom edge and a hypotenuse of the right-angled trapezoid.

Please refer to FIGS. 2 to 5, in the embodiment, the second housing 120 has the same shape as the first housing 110, with a bottom wall having a recess corresponding to the notch 102, and the notch 102 being located at the junction of a longer bottom edge and a hypotenuse of the right-angled trapezoid. A plurality of clamping posts 121 (or clamping points 111) is provided in the recess of the second housing 120, and a plurality of clamping points 111 (or clamping posts 121) is provided in the recess of the first housing 110. By means of the plurality of clamping posts 121 with the clamping points 111, the first housing 110 and the second housing 120 are clamped together to form the housing 10 with the first opening 101. The first opening 101 is located on a sidewall of the right-angled trapezoidal housing 10 and is located on the shorter bottom and hypotenuse sidewalls; the third housing 130 covers the first opening 101 and the notch 102 of the housing 10. A plurality of annular connectors 131 is provided on the third housing 130, and positions of the plurality of annular connectors 131 are corresponding to the clamping posts 121 / the clamping points 111. When the clamping post 121 and the clamping point 111 are engaged, the clamping post 121 and the clamping point 111 pass through the connector 131, and the third housing 130 is fixedly connected to the first housing and the second housing 120, in order to form the housing 10 with a receiving groove 134.

Please refer to FIGS. 2 to 7. In one embodiment of the disclosure, the charging device 11 has multiple output parts. The output parts include a first output part, a second output part and a third output part which are provided on the first housing 110. The first output part includes a first terminal 203 and a first terminal port 113, the second output part includes a second terminal 204 and a second terminal port 114, and the third output part includes an output portion 205 and a second opening 115, where the output portion 205 includes a plurality of terminals.

Please refer to FIGS. 2 to 7. In some embodiments of the disclosure, the circuit board includes a main circuit board 208 and an auxiliary circuit board 200. In an embodiment, in the receiving cavity formed by the housing 10 and on one side close to a sliding part 301, the main circuit board 208 is provided, which can be fixed on the first housing 110 through non-conductive bolts. The auxiliary circuit board 200 is also provided in the receiving cavity formed in the housing 10. The auxiliary circuit board 200 is electrically connected to the main circuit board 208, and the auxiliary circuit board 200 includes a first auxiliary circuit board 201 and a plurality of second auxiliary circuit boards 202. In an embodiment, the first auxiliary circuit board 201 is located inside the housing 10 and is arranged parallel to the first housing 110; one end of the plurality of second auxiliary circuit boards 202 is fixed on the first auxiliary circuit board 201, and the second auxiliary circuit board 202 is arranged perpendicularly to the first auxiliary circuit board 201. In one embodiment, the number of second auxiliary circuit boards 202 is, for example, four. Part of the first auxiliary circuit board 201 is electrically connected to a plurality of the first terminals 203, and remaining of the first auxiliary circuit board 201 is electrically connected to the second terminal 204. In one embodiment, for example, three first auxiliary circuit boards 201 close to the receiving groove 134 are used to electrically connect the first terminals 203, and for example, one first auxiliary circuit board 201 away from the receiving groove 134 is used to electrically connect the second terminal 204. In the embodiment, the circuit board is made from non-conductive material, such as hard plastic. The circuit board is equipped with a charging conversion circuit to convert the voltage of the alternating current or battery pack into the required voltage to charge various electronic devices. The power of the circuit board provided by the disclosure can be 5W~400W.

Please refer to FIGS. 2 to 6. In some embodiments of the disclosure, a cover 112 is provided on the first housing 110, which is located below the receiving groove 134 and higher than the surface of the first housing 110. The cover 112 is fixed on the first housing 110 and covers the plurality of the first terminals 203 and the second terminal 204; the cover 112 is also provided with a plurality of terminal ports to allow the first terminals 203 and the second terminal 204 to pass through. In an embodiment, through holes on the cover 112 includes the plurality of the first terminal ports 113, and the plurality of the first terminal ports 113 is arranged side by side on the cover 112. In the embodiment, the direction of the first opening 101 of the receiving groove 134 is defined as upward, then the plurality of the first terminal ports 113 is located below the receiving groove 134, and the plurality of the first terminal ports 113 is arranged side by side from top to bottom. The number of the first terminal ports 113 is, for example, three. In one embodiment, the plurality of the first terminal ports 113 provides passages for the plurality of the first terminals 203. The size and shape of the first terminal ports 113 are adapted to the first terminals 203, allowing the first terminals 203 to pass through the first terminal ports 113. The number of the first terminals 203 is the same as that of the first terminal ports 113, for example, three. The first terminal 203 provided in the embodiment is, for example, a type-c fast charging voltage output terminal, and each first terminal 203 can independently output a voltage. The output power of the first terminals 203 can range from 5W to 55W. The output current of first terminals 203 can range from 1A to 10A.

Further, please refer to FIGS. 2 to 6, the cover 112 is also provided with a second terminal port 114. In one embodiment, the second terminal port 114 is located below the receiving groove 134, and the second terminal port 114 is arranged side by side with the plurality of the first terminal ports 113, the number of second terminal ports 114 is, for example, one. In one embodiment, the second terminal port 114 provides a passage for the second terminal 204, and the size and shape of the second terminal port 114 are adapted to the second terminal 204, allowing the second terminal 204 to pass through the second terminal port 114. The second terminal 204 provided in the embodiment is, for example, a Universal Serial Bus (USB) voltage output terminal. The output power of the second terminal 204 can range from 5W-55W, and the output current of the second terminal 204 can range from 1A~10A.

Referring to FIGS. 1, 2, 5 and 7, the first housing 110 is also provided with a second opening 115. In one embodiment, when the charging device 1 is placed vertically (the opening of the receiving groove 134 faces upwards), the second opening 115 and the second terminal port 114 on the cover 112 are located on the same horizontal plane. The second opening 115 provides a channel for the output portion 205. The output portion 205 charges the battery pack 3 or receives the discharge of the battery pack 3. The output power of the output portion 205 can range from 10W to 200W, and the output current of the output portion 205 can range from 0.5A-10A. When the charging device 1 is not connected to an external power source, the battery pack 3 can also be connected to the output portion 205 to provide voltage input to the circuit board through the output portion 205. Through the charging conversion circuit on the circuit board, voltage output can be provided to the first terminal 203, the second terminal 204, or a fourth terminal 206.

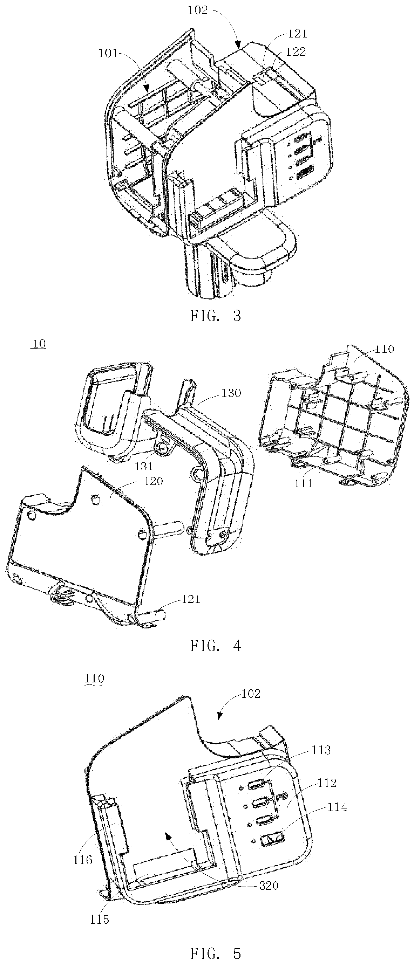

Please refer to FIGS. 2 and 5, in some embodiments, the output portion 205 is an exposed metal terminal. An output protection device 300 is provided at the second opening 115 to ensure the safety of operation, which ensures that when there is no electronic device on the output portion 205, the output portion 205 is covered.

Please refer to FIGS. 1, 5, 8 to 16. An output protection device 300 is provided outside the housing 10 so that the third output part is exposed when charging the battery pack 3. When not charging, the third output part is covered by the output protection device 300. In an embodiment, when the battery pack 3 needs to be charged, the charging port of the battery pack 3 is electrically connected to the output portion 205 to realize charging of the battery pack 3. When the battery pack 3 is placed in the recess 320, the output portion 205 is exposed, and the charging device 1 is connected to the battery pack 3 to charge the battery pack 3. When the charging is completed, the battery pack 3 is disconnected from the output portion 205, and the battery pack is 3 is taken out from the recess 320, and the output portion 205 is covered, which greatly improves the safety of the charging device 1 and also greatly improves the convenience of use.

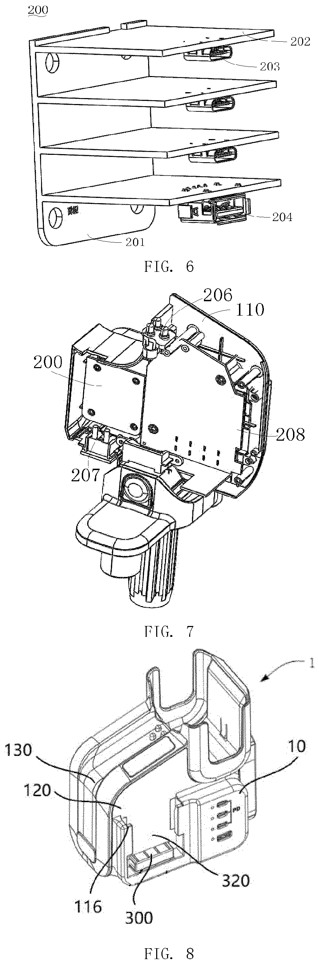

Referring to FIGS. 8 to 16, the disclosure provides an output protection device 300 including: a sliding part 301 and a fixing part 307. The fixing part 307 is arranged in the receiving cavity of housing and is fixedly connected to the inside of the first housing 110. The sliding part 301 is arranged between the fixing part 307 and the first housing 110 to allow the sliding part 301 to slide between a first position and a second position. One end of the output portion 205 passes through the fixing part 307, the sliding part 301 and the first housing 110 in sequence, and exposes from the first housing 110. When the sliding part 301 is in the first position relative to the fixing part 307, the sliding part 301 covers the output portion 205. When the sliding part 301 is in the second position relative to the fixing part 307, the output portion 205 is at least partially exposed to the sliding part 301.

Please refer to FIGS. 8 to 16. In some embodiments, the first housing 110 may be provided with a second opening 115. One end of the output portion 205 passes through the fixing part 307, the sliding part 301, and the second opening 115 on the first housing 110 in sequence, and exposes to outside of the first housing 110.

Please refer to FIGS. 4, 13, 15 and 16. In some embodiments, a plurality of first grooves 302 may be provided inside the first housing 110, and the first grooves 302 extend along the sliding direction of the sliding part 301. In one embodiment, two first grooves 302 are provided inside the first housing 110. The two first grooves 302 are located on one side of the second opening 115. In the embodiment, the two first grooves 302 are located above the second opening 115. And the two first grooves 302 are parallel to each other and have equal lengths.

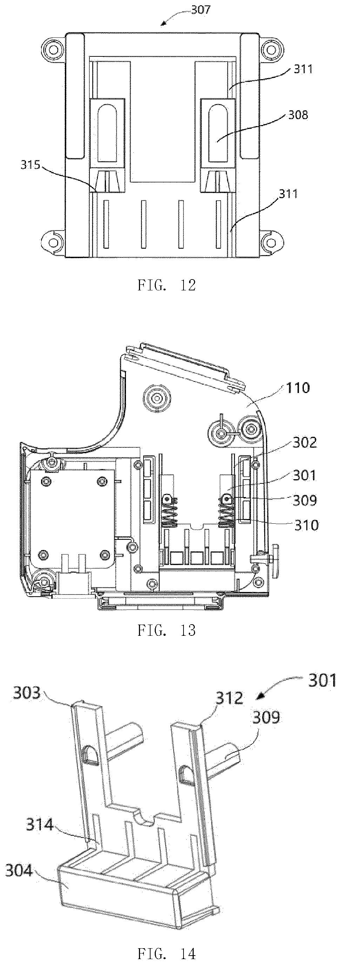

Please refer to FIGS. 14 to 16. In some embodiments, the sliding part 301 is provided with a sliding protrusion 304 arranged close to the second opening 115 and bent toward the second opening 115 to fit the second opening 115. The sliding protrusion 304 is inserted into the second opening 115 and the sliding protrusion 304 can slide in the second opening 115. The output portion 205 is covered or exposed by sliding the sliding protrusion 304 in the second opening 115.

Please refer to FIGS. 14 to 16. In some embodiments, a plurality of sliding columns 309 perpendicular to the plane of the sliding part 301 is provided on the side surface that is of the sliding part 301 and that is away from the sliding protrusion 304. The plurality of the sliding columns 309 is arranged on the side of the sliding part 301 that is away from the sliding protrusion 304. In one embodiment, for example, the sliding part 301 may be provided with two sliding columns 309, and the two sliding columns 309 are respectively located on two sides of the second opening 115.

Please refer to FIG. 14. In some embodiments, a plurality of L-shaped narrow slits 314 is formed on a side surface of the sliding protrusion 304 close to the sliding column 309. One leg of the L-shaped narrow slit 314 is located on the sliding protrusion 304, and the other leg of the L-shaped narrow slit 314 is located on the surface of the sliding part 301, and the L-shaped narrow slit 314 allows the output terminal to pass through and be exposed.

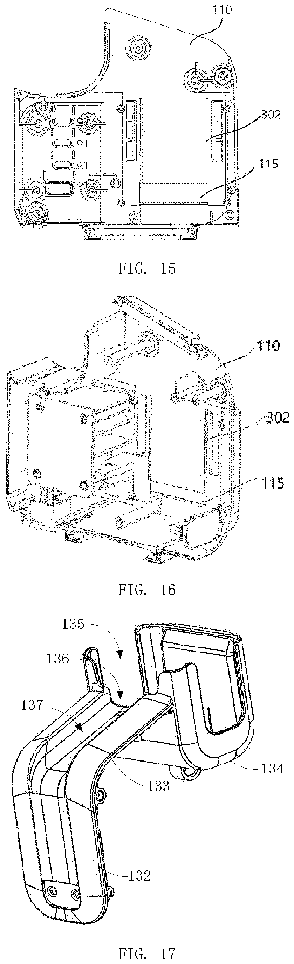

Please refer to FIGS. 14 and 16. In some embodiments, a plurality of first protruding ribs 303 is provided on the side of the sliding part 301 facing the first housing 110. The first protruding ribs 303 cooperate with the first groove 302. The first protruding rib 303 is allowed to slide within the first groove 302. In one embodiment, the sliding part 301 is provided with two first protruding ribs 303 that are parallel to each other and of equal length. The first protruding ribs 303 cooperate with the first grooves 302 to allow the first protruding ribs 303 to slide in the first groove 302.

Please refer to FIGS. 12 to 16. In some embodiments, the fixing part 307 is provided with at least one first through hole 308. The first through hole 308 is elongated and extends along a sliding direction of the sliding part 301. In one embodiment, the fixing part 307 is provided with, for example, two first through holes 308. The two first through holes 308 are respectively located on two sides of the second opening 115 and correspond to the position of the sliding columns 309. The sliding column 309 can pass through the corresponding first through hole 308, and the sliding column 309 can move along the extension direction of the first through hole 308 to realize the sliding part 301 to slide between the first position and the second position. In an embodiment, when the sliding column 309 is located at the end of the first through hole 308 away from the output portion 205, it means that the sliding part 301 is in the first position relative to the fixing part 307. When the sliding column 309 is located at the end of the first through hole 308 close to the output portion 205, it means that the sliding part 301 is in the second position relative to the fixing part 307.

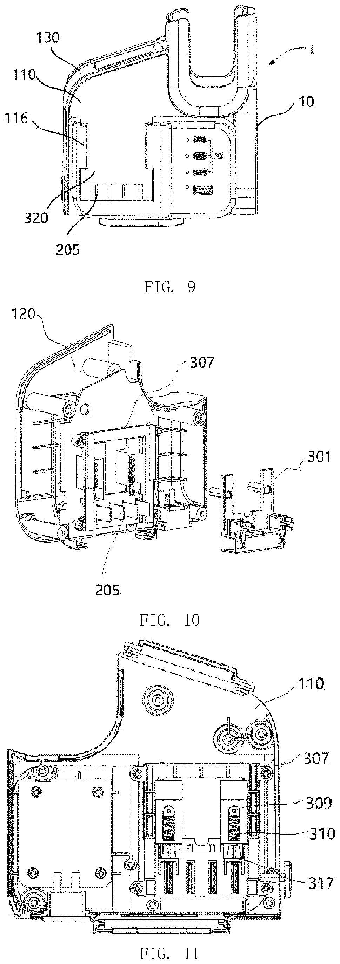

Please refer to FIGS. 11 to 13. In some embodiments, the plane where the first through hole 308 is located protrudes from the plane where the fixing part 307 is located, and the plane where the first through hole 308 is located is arranged on the fixing part 307 away from the sliding part 301.

Referring to FIGS. 11 and 12, in some embodiments, a plurality of fixing members 315 is provided on the side of the fixing part 307 away from the sliding part 301, and the fixing members 315 are located between the output portion 205 and the first through hole 308. In one embodiment, two T-shaped fixing members 315 are provided on the fixing part 307, and each T-shaped fixing member 315 is correspondingly arranged between the first through hole 308 and the output portion 205.

Referring to FIGS. 11 to 14, in some embodiments, an elastic member 310 is provided between the sliding part 301 and the fixing part 307. The elastic member 310 may be a spring, for example, or other elements that can achieve stretching and compression functions. In an embodiment, one end of the elastic member 310 is sleeved on the fixing member 315, and the other end of the elastic member 310 abuts against the sliding column 309.

Please refer to FIG. 15. In some embodiments, a plurality of second protruding ribs 312 is provided on the side of the sliding part 301 away from the sliding protrusion 304. In one embodiment, for example, two second protrusion ribs 312 are provided on the sliding part 301. The two second protruding ribs 312 are parallel to each other, and the two second protruding ribs 312 are arranged on two sides of the sliding columns 309.

Please refer to FIG. 4, FIG. 13 and FIG. 15. In some embodiments, on one side of the fixing part 307 is provided with a plurality of second grooves 311 adjacent to the sliding part 301. The second grooves 311 are extended along the sliding direction of the sliding part 301. The second protruding ribs 312 cooperate with the second grooves 311 to allow the second protruding ribs 312 to slide within the second grooves 311. In one embodiment, the fixing part 307 is provided with, for example, two second grooves 311, each second groove 311 broken in the center. In other embodiments, the number of the second grooves 311 and the second protruding ribs 312 can also be other values.

Please refer to FIGS. 1 to 16. During use, the battery pack 3 is slid into the recess 320 from the guide rail 116 by external force, and contacts the sliding protrusion 304 covering the output portion 205. During the process of pressing down the sliding protrusion 304, the battery pack 3 drives the sliding column 309 to slide in the first through hole 308 in a direction towards the output portion 205. The sliding part 301 slides relative to the first housing and the fixing part 307 through the cooperations between the first groove 302 and the first protruding rib 303 and between the second groove 311 and the second protruding rib 312, so that the elastic member 310 changes from the initial state to the compressed state. Then the sliding part 301 moves from the first position to the second position relative to the fixing part 307. When the sliding part 301 reaches the second position, the output portion 205 exposes from the sliding protrusion 304. When the battery pack 3 is separated from the recess 320 via the guide rail 116 by external force, the elastic member 310 gradually returns from the compressed state to the initial state, driving the sliding column 309 to slide in the first through hole 308 in the direction away from the output portion 205. Through the cooperation between the first groove 302 and the first protruding rib 303 and between the second groove 311 and the second protruding rib 312, the sliding part 301 slides relative to the first housing 110 and the fixing part 307, until the sliding part 301 is moved from the second position to the first position. When the sliding part 301 reaches the first position, the sliding protrusion 304 covers the output portion 205.

Please refer to FIG. 2, FIG. 4 and FIG. 17. In some embodiments of the disclosure, a fourth output part is also provided on the third housing 130. The fourth output part includes a fourth terminal 206 and a fourth terminal port 138. In an embodiment, the third housing 130 includes a first plane 132, a second plane 133 and a receiving groove 134. The first plane 132 is smoothly connected to one side of the second plane 133, and the other side of the second plane 133 is connected to an outer side wall of the receiving groove 134. The first plane 132 covers the first opening 101 on the shorter bottom of the housing 10, the second plane 133 covers the first opening 101 on the hypotenuse of the housing 10, and the receiving groove 134 is arranged in the notch 102 on the housing 10. In the embodiment, the first plane 132 and the second plane 133 are arranged at a first angle, that is, the shorter bottom and the hypotenuse of the housing 10 are arranged at a first angle, and the range of the first angle is, for example, from 90° to 145°. In one embodiment, the first angle is set to 120°. When the first plane 132 and the second plane 133 are arranged at a first angle, they are adapted to a vacuum cleaner 6 and the battery pack 3 configured with the vacuum cleaner 6 provided by a embodiment of the disclosure. In the embodiment, the first plane 132, the second plane 133 and the receiving groove 134 of the third housing 130 may be integrally formed, or may be fixed together by welding, snapping or other methods.

Please refer to FIG. 2. In one embodiment of the disclosure, a rubber pad 141 is provided on the first plane 132, which is located on a side of the first plane 132 away from the second plane 133, and the rubber pad 141 is higher than the first plane. 132. When the charging device 1 provided by the disclosure is used to charge the vacuum cleaner 6, the rubber pad 141 provides a buffer force to prevent the vacuum cleaner 6 and the charging device 1 from colliding and causing damage. The material of the rubber pad 141 is, for example, thermoplastic urethane elastomer (TPU).

Please refer to FIGS. 2 and 17. In one embodiment of the disclosure, a concave part 137 is provided on the second plane 133 and along the direction of the hypotenuse (hypotenuse) of the housing 10. The depth of the concave part 137 fits the electronic device engaged thereof, in order to clamp electronic device that needs to be charged. In one embodiment, the electronic device is a vacuum cleaner 6. Please refer to FIG. 2 and FIG. 7 together. A plurality of fourth terminal ports 138 is provided on the side that is of the concave part 137 of the second plane 133 and is close to the receiving groove 134. The fourth terminal 206 passes through the fourth terminal port 138 and is exposed on the second plane 133, and the fourth terminal 206 is a dedicated terminal for the vacuum cleaner 6, used for charging the dedicated vacuum cleaner 6. The output power of the fourth terminal 206 can range from 10W to 200W, the output current of the fourth terminal 206 may range from 0.5A to 10A. In one embodiment, the number of the fourth terminal ports 138 is, for example, three, and they are arranged in an equilateral triangle shape.

Please refer to FIGS. 2 and 7. In one embodiment of the disclosure, a display device 143 is provided on the second plane 133 and on one side of the concave part 137, and the display device 143 is arranged on one side close to the first housing 110, in order to display the position on the concave part 137 in the dark. The display device 143 is electrically connected to the main circuit board 208 and is used to display the voltage status of the charging conversion circuit. In one embodiment, the material of the display device 143 is, for example, polycarbonate (PC).

Please refer to FIGS. 2 to 4 and as shown in FIG. 17, in one embodiment of the disclosure, the receiving groove 134 is U-shaped, and the side of the second plane 133 is fixed to an outer wall of the receiving groove 134. The side wall of the receiving groove 134 connected to the second plane 133 and bottom wall of the receiving groove 134 are adapted to fit the notch 102. In the embodiment, the side walls of the receiving groove 134 exceed the height of the second plane 133 to maintain the stability of the electronic device placed in the receiving groove 134. In order to ensure that the side wall of the receiving groove 134 are smoothly connected to the second plane 133, a first concave 136 is provided on the side wall that is of the receiving groove 134 and that is connected to the second plane 133. The size of the receiving groove 134 is adapted to the size of the battery pack 3, and symmetrical first opening grooves 135 are provided at both ends of the receiving groove 134. The first opening groove 135 has a first preset distance from the bottom wall of the receiving groove 134 and has a second preset distance to the side wall of the receiving groove 134, in order to ensure that the battery pack 3 of the vacuum cleaner 6 is fixed. And when it is necessary to charge electronic devices such as mobile phones and tablets, the electronic devices can be placed on the first opening groove 135.

Further, please refer to FIGS. 2 to 4 and FIGS. 17 to 18. In one embodiment of the disclosure, the connector 131 is also provided at the bottom of the receiving groove 134 and the connector 131 is annular. A through hole 122 is provided on the notch 102 corresponding to the connector 131. A clamping post 121 connecting the first housing 110 and the second housing 120 is provided in the through hole 122. When the receiving groove 134 covers the notch 102, the clamping post 121 passes through the annular connector 131 to securely connect the third housing 130 to the first housing 110 and the second housing 120.

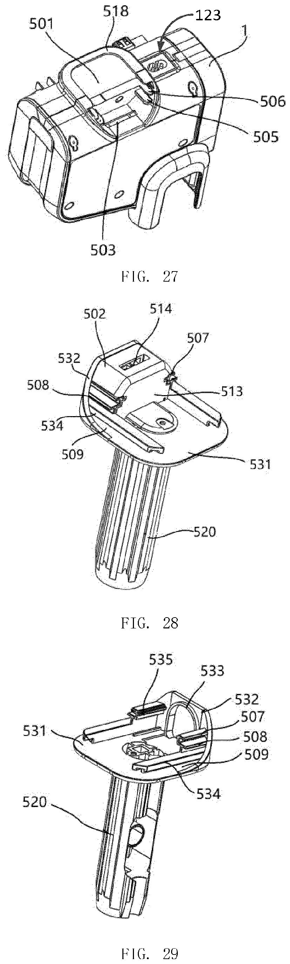

Please refer to FIG. 7 and FIG. 27. In one embodiment of the disclosure, an input part of the charging device is provided at the bottom of the charging device 1 which is on one surface of the charging device 1 opposite to the receiving groove 134. The input part includes a fifth terminal port 123 and a fifth terminal 207. The fifth terminal port 123 allows the fifth terminal 207 to pass through. The fifth terminal 207 is electrically connected to the input end of the circuit board and is a voltage input terminal, used to provide power to the charging device 1. In one embodiment, the input voltage of the fifth terminal 207 may range from 110V to 250V, for example, and the fifth terminal 207 is an AC input.

Please refer to FIGS. 1 to 2. The charging device 1 provided by some embodiments of the disclosure has a variety of fixing methods. A wall-mounted locking device is provided on an outer wall that is of the receiving groove 134 and that is opposite to the second plane 133, in order to hang the charging device 1 on the wall.

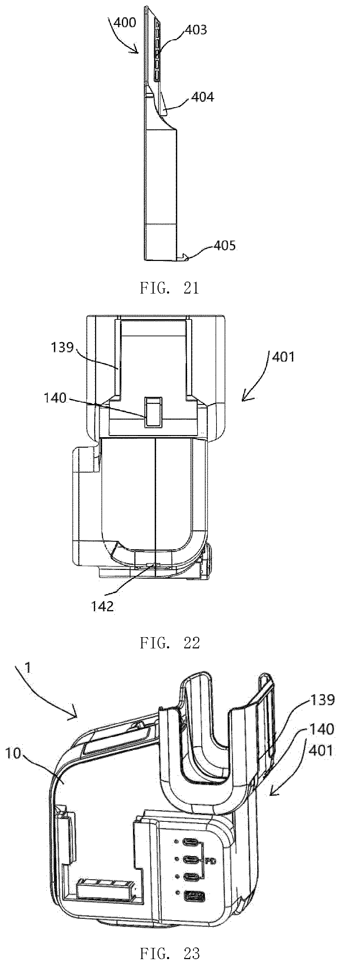

Please refer to FIGS. 2, 19 to 24. Some embodiments of the disclosure provide a wall-mounted locking device, which includes: a backboard body 400 and a backboard mating part 401, wherein the backboard body 400 is arranged on a vertical wall., the backboard mating part 401 is arranged on the housing 10, the backboard mating part 401 cooperates with the backboard body 400 to fix the object to be hung on the vertical wall. The vertical wall may be, for example, a wall, a side wall of a fixed device, a relatively fixed side wall of a movable device, or a movable side wall. The backboard body 400 is provided with at least one through hole 402, and the backboard body 400 is fixed to the vertical wall by passing a fixing piece through the through hole 402. The fixing piece may be an expansion screw, a screw, or a bolt. In one embodiment, for example, two through hole 402 are respectively provided near the upper part and near the lower part of the backboard body 400, and the backboard body 400 is fixed and hung on the wall via screws and bolts. In other embodiments, the through holes can also be provided at other positions of the backboard body 400, as long as they can be used to fix the backboard body 400 on a vertical wall, which is not limited in the disclosure.

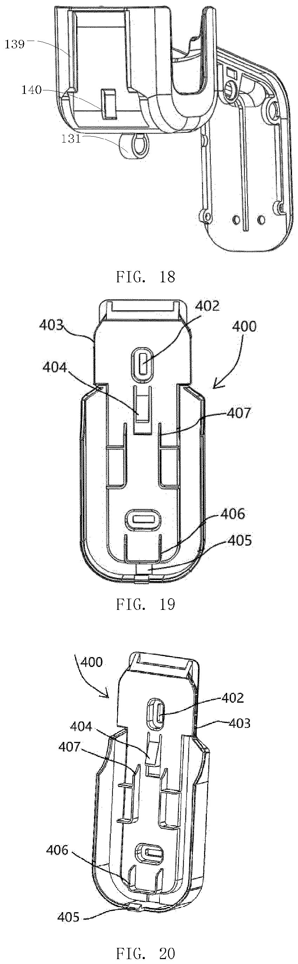

Referring to FIGS. 19 to 21, in some embodiments, the backboard body 400 may include: a slideway 403 and a clamping member. The clamping member at least includes a first clamping member 404 and a second clamping member 405. In some embodiments, the number of slideways 403 may be more than one. The plurality of slideways 403 is vertically fixed on the backboard body 400 so that the object to be hung slides on the slideways 403 and is fixed to the backboard body 400. In the embodiment, the slideway 403 includes a first slideway and a second slideway, which are symmetrically arranged on the backboard body 400. For example, the first slideway and the second slideway are symmetrically arranged on two sides the backboard body 400 and are parallel to the plane where the backboard body 400 is located.

Referring to FIGS. 19 to 21, in some embodiments, the slideway 403 can be a convex structure. In other embodiments, the slideway 403 can also be a groove structure, or a magnetic structure. The slideway 403 may be arranged to allow the object to be hung to slide on the slideway 403, and the specific form of the slideway 403 is not limited.

Please refer to FIGS. 19 to 21. In some embodiments, a first clamping member 404 is also provided on the backboard body 400. In one embodiment, the first clamping member 404 is provided between the slideways 403 on both sides of the backboard body 400 and is arranged on one side of the slideways 403. In other embodiments, the first clamping member 404 can also be arranged at other positions on the backboard body 400, such as in the middle of the two slideways 403, as long as the first clamping member 404 can be used to fix the hanging object, and the specific location of the first clamping member 404 is not limited in the disclosure. The upper and lower positions of the object to be suspended on the backboard body 400 are fixed through the first clamping member 404.

Referring to FIGS. 19 to 21, in some embodiments, the first clamping member 404 may be a movable clamping member which allowing the first clamping member 404 to move in a direction away from the backboard mating part 401 under the action of external force. In one embodiment, the side of the first clamping member 404 close to the slideway 403 is connected to the backboard body 400, while the other side of the first clamping member 404 is freely suspended. When an external force acts on the side of the first clamping member 404 away from the side connected to the backboard body 400, this forced side on the first clamping member 404 can move in a direction away from the backboard mating part 401. When the external force is lost, this side on the first clamping member 404 away from the side connected to the backboard body 400 returns to its original position, thereby realizing the connection and fixation of the object to be hung with the backboard body 400.

Please refer to FIGS. 19 to 21. In some embodiments, a second clamping member 405 can be arranged on a bottom side of the backboard body 400. In some embodiments, the second clamping member 405 can be an inactive clamping member. In some other embodiments, the second clamping member 405 may also be an active clamping member, which is not limited in the disclosure. The second clamping member 405 is used to limit the forward and backward movement of the object to be hung.

Referring to FIGS. 19 to 21, in some embodiments, the second clamping member 405 can be in the form of a hook. In an embodiment, the second clamping member 405 can include a connecting arm and a hook, where one end of the connecting arm is installed on the back surface of the backboard body 400, the connecting arm and the surface of the backboard body 400 are arranged non-parallel, and there is an angle between the connecting arm and the surface of the backboard body 400. In one embodiment, the angle between the connecting arm and the surface of the backboard body 400 is, for example, 90°. In other embodiments, the angle between the connecting arm and the surface of the backboard body 400 can be selected from 0° to 180°. An end of the connecting arm away from the backboard body 400 is provided with the hook, and an end of the hook extends in a direction toward the object to be hung.

Please refer to FIGS. 19 to 21. In some embodiments, the backboard body 400 can also be provided with a first supporting plate 406. The first supporting plate 406 can be arranged at the bottom of the backboard body 400. The first supporting plate 406 may extend outwards in a direction perpendicular to the plane of the backboard body 400, and an opening direction of the first supporting plate 406 is toward the top of the backboard body 400.

In some embodiments, the first supporting plate 406 is provided with a bent portion toward the top of the backboard body 400 to resist the backboard mating part 401 and prevent the backboard mating part 401 from shaking. For example, the first supporting plate 406 is set to U-shape, inverted trapezoid or concave shape.

Please refer to FIGS. 19 to 21. In some embodiments, the backboard body 400 can also be provided with a second supporting plate 407, and the second supporting plate 407 can be arranged between the slideway 403 and the first supporting plate 406, to further enhance the resistance of the backboard body 400 to objects to be hung. In one embodiment, the second supporting plate 407 is provided on the backboard body 400, and the second supporting plate 407 includes a connecting plate and a plurality of supporting pieces. The connecting plate is arranged in the vertical direction. The multiple supporting pieces are spaced and fixedly connected to the connecting plate and the backboard body 400, and are perpendicular to the connecting plate to resist the objects to be hung in the horizontal direction and prevent shaking caused by a gap between the backboard mating part 401 and the backboard body 400, which makes the connection between the backboard mating part 401 and the backboard body 400 more stable.

Please refer to FIGS. 19 to 22 together. The wall-mounted locking device of the disclosure also includes a backboard mating part 401. The backboard mating part 401 is provided on the object to be hung. The backboard mating part 401 is used to cooperate with the backboard body 400. The backboard mating part 401 may include: a matching slideway 139 and a locking slot, which at least includes a first locking slot 140 and a second locking slot 142.

Please refer to FIGS. 19 to 22 together. The number of matching slideways 139 can be set according to the number of slideways 403 on the backboard body 400. In one embodiment, because the slideways 403 on the backboard body 400 include a first slideway and a second slideway. Therefore, the matching slideways 139 also includes a first matching slideway and a second matching slideway. The first matching slideway and the second matching slideway are symmetrically arranged on two sides of the backboard mating part 401, and cooperate with the first slideway and the second slideway respectively, allowing the slideway 403 to slide in the matching slideway 139.

Please refer to FIGS. 19 to 22 together. In some embodiments, the matching slideway 139 can be a convex structure. In other embodiments, the matching slideway 139 can also be a concave structure, or a magnetic structure. The matching slideway 139 here can match the slideway 403 so that the object to be hung can slide on the slideway 403. The specific form of the matching slideway 139 is not limited.

Please refer to FIGS. 19 to 22 together. In some embodiments, for example, the slideway 403 has a convex structure, and the matching slideway 139 has a concave structure. In one embodiment, for example, two protruding structures can be provided on two sides of the backboard body 400, correspondingly, two groove structures are provided on the object to be hung. The size of the groove structure matches the size of the protruding structure, allowing the two protruding structures on the backboard body 400 to slide in the groove structures. In the embodiment, the protruding structure is, for example, a strip structure protruding from the surface of the backboard body 400. In other embodiments, the protruding structure may also be a point structure protruding from the surface of the backboard body 400, or in other forms. The shape of the protruding structure is not specifically limited in the disclosure, as long as the protruding structure can be embedded in the corresponding groove structure to achieve sliding. In some embodiments, the length of the protruding structure may be the same as the length of the side of the backboard body 400. In other embodiments, the length of the protruding structure may be smaller than the length of the side of the backboard body 400.

Please refer to FIGS. 19 to 22 together. In some embodiments, when the first clamping member 404 is provided on the backboard body 400, a first locking slot 140 is correspondingly provided on the backboard mating part 401. In one embodiment, the first locking slot 140 is arranged on one side of the matching slideway 139 and cooperates with the first clamping member 404, allowing the first clamping member 404 to be embedded in the first locking slot 140. In other embodiments, the specific position of the first locking slot 140 can be set according to the position of the first clamping member 404, which is not limited in the disclosure.

Please refer to FIG. 2, FIG. 19 to FIG. 22 together. In some embodiments, a release button 408 is provided on the side of the first locking slot 140 away from the backboard body 400. When the object to be hung is fixed on the backboard body 400, the release button 408 is pressed, then the first clamping member 404 moves in a direction away from the backboard mating part 401 under the action of the release button 408, so that the first clamping member 404 is disengaged from the first locking slot 140. Thus, the disassembly process between the backboard body 400 and the backboard mating part 401 is completed, and the hanging object can be separated from the backboard body 400.

Please refer to FIGS. 19 to 22 together. In some embodiments, when the backboard body 400 is provided with the second clamping member 405, the backboard mating part 401 is correspondingly provided with a second locking slot 142. In the embodiment, the second locking slot 142 is provided on a side of the backboard mating part 401 near the bottom. In other embodiments, the position of the second locking slot 142 can be determined according to the position of the second clamping member 405. The second locking slot 142 cooperates with the second clamping member 405 to allow the second clamping member 405 to be embedded in the second locking slot 142. A cooperation of the second clamping member 405 and the second locking slot 142 may prevent the backboard body 400 from sliding relative to the backboard mating part 401, in order to achieve the fixation of the object to be hung and the backboard body 400. In some embodiments, when the second clamping member 405 is a movable clamping member, a release button may be provided on the side of the second locking slot 142 away from the backboard body 400 for pressing the second clamping member 405.

Please refer to FIG. 2, FIG. 23 and FIG. 24. The backboard mating part 401 can be an independent component, or it can be a part of the charging device 1. For example, in one embodiment, the backboard mating part 401 is formed on the outer side wall of the receiving groove 134 of the charging device 1. The backboard mating part 401 is designed, for example, in a stepped shape according to the structure of the charging device 1, with the upper half of the stepped shape protruding from the lower half. The backboard mating part 401 cooperates with the backboard body 400 fixed on the wall to hang the charging device 1 on the wall.

Referring to FIG. 2, FIG. 19 to FIG. 24, the backboard body 400 includes a slideway 403, a first clamping member 404, a second clamping member 405, a first supporting plate 406 and a second supporting plate 407. In one embodiment, the length of the slideway 403 is, for example, less than the side length of the backboard body 400 and less than or equal to the length of the upper half step of the charging device 1. Correspondingly, the backboard mating part 401 is provided with a matching slideway 139, a first locking slot 140 and a second locking slot 142. In one embodiment, the number of the matching slideways 139 is, for example, two, which are arranged in parallel along the direction of the side wall. The charging device 1 slides and snaps into the backboard body 400 through the matching slideways 139, thereby being fixed on the wall. The first locking slot 140 is arranged on one side of the two parallel matching slideways 139 and on the side away from the opening of the receiving groove 134. The second locking slot 142 is arranged on the bottom of the charging device 1. When the backboard mating part 401 is slid into the backboard body 400, the first locking slot 140 and the second locking slot 142 limit the position of the backboard mating part 401. The first supporting plate 406 is used to support the bottom of the charging device 1, and the second supporting plate 407 is used to support the upper stepped portion of the charging device 1.

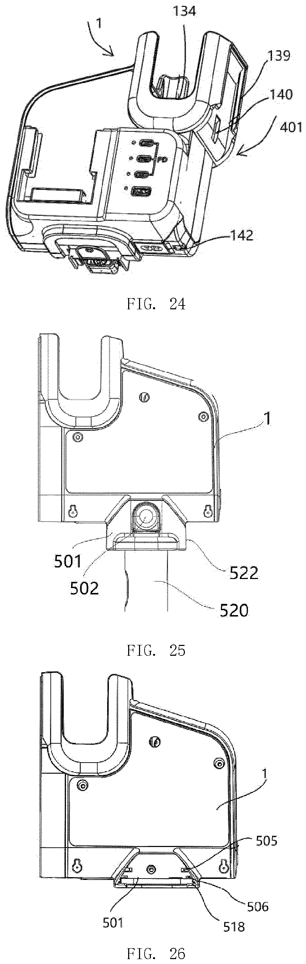

Referring to FIGS. 25 to 28, Some embodiments of the disclosure provide a locking structure 522 for the charging device 1. The charging device 1 is connected to the fixed base 520 through the locking structure 522. The locking structure 522 includes: a first locking unit 501 and a second locking unit 502. The first locking unit 501 and the second locking unit 502 can cooperate with each other to realize the locking and disengage between the charging device 1 and the fixed base 520. In some embodiments, the first locking unit 501 is provided on the charging device 1. In an embodiment, one side of the first locking unit 501 is fixed on the bottom of the charging device 1. The first locking unit 501 is provided with a locking groove 503. The locking groove 503 is provided on one side of the plurality of sliding ribs, and the locking groove 503 is located on the side that is of the first locking unit 501 and that is connected to the bottom of the charging device 1. The second locking unit 502 is arranged on the fixed base 520. The second locking unit 502 is provided with a locking block 504. By moving the locking block 504, the locking block 504 can be inserted into the locking groove 503 or disengaged from the locking groove 503. When the locking block 504 is inserted into the locking groove 503, the first locking unit 501 and the second locking unit 502 are fitted and locked. When the locking block 504 is disengaged from the locking groove 503, the first locking unit 501 and the second locking unit 502 unlocks.

Please refer to FIG. 26 and FIG. 27. The first locking unit 501 can be provided with multiple sliding ribs. The sliding ribs are parallel to the bottom plane of the charging device 1. The multiple sliding ribs are parallel to each other, and the multiple sliding ribs are parallel to each other. The sliding ribs are respectively located on both sides of the bottom of the charging device 1.

Please refer to FIG. 26 and FIG. 27. For example, the first locking unit 501 is provided with two first sliding ribs 505 and two second sliding ribs 506. The first sliding ribs 505 and the second sliding ribs 506 are parallel to the bottom plane of the charging device 1. The first sliding ribs 505 and the second sliding ribs 506 are parallel to each other. The two first sliding ribs 505 are respectively located on two sides of the bottom of the charging device 1, two second sliding ribs 506 are also located on two sides of the bottom of the charging device 1, and the second sliding ribs 506 are located on the side of the first sliding rib 505 away from the bottom of the charging device 1.

Please refer to FIG. 26 and FIG. 27. In some embodiments, the first sliding rib 505 and the second sliding rib 506 have the same or different lengths. In one embodiment, the lengths of the first sliding rib 505 and the second sliding rib 506 are different, and the length of the first sliding ribs 505 is greater than the length of the second sliding ribs 506. One end of the first sliding ribs 505 and the second sliding ribs 506 are flush.

Please refer to FIG. 26 and FIG. 27. In some embodiments, the width between the two first sliding ribs 505 and the width between the two second sliding ribs 506 are different. The width between the second sliding ribs 506 is larger than that of the two first sliding ribs 505. In an embodiment, the distance between the two first sliding ribs 505 is, for example, 20mm-50mm. In an embodiment, the distance between the two first sliding ribs 505 is 30mm-40mm, for example, 38.7mm. The distance between the two second sliding ribs 506 is, for example, 30mm-60mm. In an embodiment, the distance between the two second sliding ribs 506 is 40mm-50mm, and for example, 47.3mm.

Please refer to FIGS. 26 and 27. In some embodiments, a third sliding rib 518 can be provided on the side of the second sliding rib 506 away from the first sliding rib 505. The third sliding rib 518 can be arranged in a U shape, and the front, middle and rear sections of the charging device 1 on the horizontal axis are fixed through three sliding ribs. The width between the two sides of the U shape is, for example, 40mm-70mm. In an embodiment, the width between the two sides of the U shape is 50mm-60mm, for example, 57.8mm. The width between two sides of the third sliding rib 518 is greater than the width between the two first sliding ribs 505 and greater than the width between the two second sliding ribs 506.

In addition, the distance between the first sliding rib 505 and the second sliding rib 506 is, for example, 1mm-5mm. In an embodiment, the distance between the first sliding rib 505 and the second sliding rib 506 is 2mm-4mm, and for example, 2.9mm. The distance between the second sliding rib 506 and the third sliding rib 518 is, for example, 2 mm-8 mm. In an embodiment, the distance between the second sliding rib 506 and the third sliding rib 518 is 3-7 mm, for example, 4 mm.

Please refer to FIG. 27. In some embodiments, the locking groove 503 is provided on the bottom plane of the charging device 1. The length of the locking groove 503 is, for example, 10mm-40mm. In an embodiment, the length of the locking groove 503 is 15mm-30mm, for example, 29mm. In some embodiments, the width of the locking groove 503 is, for example, 2mm-6mm. In an embodiment, the width of the locking groove 503 is 3mm-5mm, for example, 4.6mm. In some embodiments, the distance between the locking groove 503 and the housing of the charging device 1 is, for example, 8mm-15mm. In an embodiment, the distance between the locking groove 503 and the housing of the charging device 1 is 10mm-13mm, for example 11.9mm.

Please refer to FIG. 27 and FIG. 28 together. In some embodiments, the second locking unit 502 may be provided with multiple matching sliding ribs, the matching sliding ribs are parallel to the sliding ribs, and the multiple matching sliding ribs are parallel to each other. The matching sliding ribs in the second locking unit 502 are misaligned with the sliding ribs in the first locking unit 501. When the first locking unit 501 and the second locking unit 502 are fitted, the sliding ribs and matching sliding ribs in the two locking units form an interleaved structure, so that the connection between the first locking unit 501 and the second locking unit 502 is more stable after they are fitted.

Please refer to FIGS. 27 and 28 together. In one embodiment, according to the number of sliding ribs in the first locking unit 501, for example, two first matching sliding ribs 507 and two second matching sliding ribs 508 are provided in the second locking unit 502. The first matching sliding ribs 507 and the second matching sliding ribs 508 are parallel to the sliding ribs, and the first matching sliding rib 507 and the second matching sliding rib 508 are parallel to each other.

Please refer to FIG. 27 and FIG. 28 together. When the first locking unit 501 and the second locking unit 502 are coupled, the first sliding rib 505 and the first matching sliding rib 507 are interspersed and fitted, and the second sliding ribs 506 and the second matching sliding ribs 508 are interspersed and fitted. When the charging device 1 is connected to the fixed base 520, the first sliding ribs 505 and first matching sliding ribs 507, and the second sliding ribs 506 and second matching sliding rib 508, are interspersed and fitted with each other at the same time to firmly connect the charging device 1 to the fixed base 520 and improve the strength of the structure. The first sliding ribs 505 and first matching sliding ribs 507, the second sliding rib 506 and the second matching sliding rib 508, are in interspersed and fitted connection, thus ensuring that the structure is not prone to shaking.

Please refer to FIGS. 27 and 28 together. In some embodiments, the lengths of the multiple matching sliding ribs may be different. The length of the matching sliding ribs may be determined according to the length of the corresponding sliding ribs and according to the shape and size of the unit 502, which only needs to ensure that there is no gap between the sliding ribs and the mating sliding ribs. In one embodiment, for example, when the first locking unit 501 and the second locking unit 502 are fitted, the length of the first matching sliding rib 507 is greater than the length of the second matching sliding rib 508.

Please refer to FIGS. 27 and 28 together. In some embodiments, the second locking unit 502 is also provided with a third matching sliding rib 534, in order to be interspersed and fitted with the third sliding rib 518 in the first locking unit 501, to further improve the structural strength and stability of the locking structure.

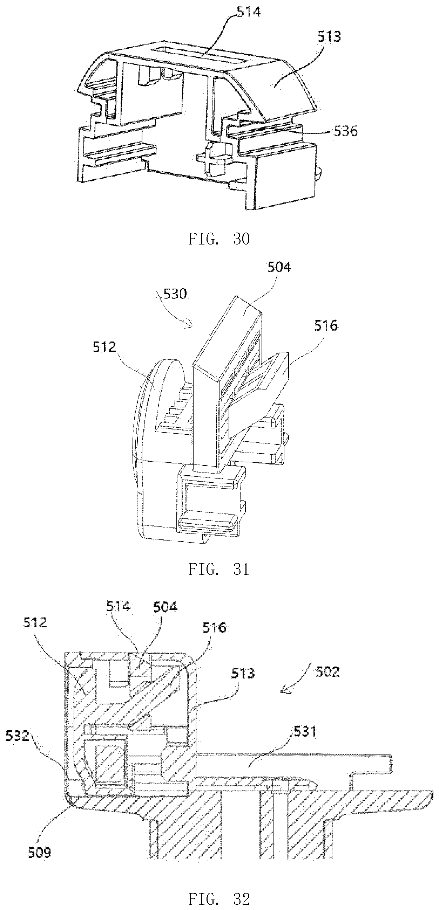

Please refer to FIGS. 28 to 31 together. In some embodiments, the second locking unit 502 may also include a locking base 509, a locking cover 513 and a locking member 530. The locking base 509 is, for example, L-shaped. The part of the L-shaped locking base 509 that is parallel to the end surface of the fixed base 520 is defined as a horizontal part 531. The part of the L-shaped locking base 509 that is perpendicular to the end surface of the fixed base 520 is defined as a vertical part 532. There is a button hole 533 on the vertical part 532. In the, multiple matching sliding ribs are symmetrically distributed on both sides of the button hole 533, and one end of the matching sliding ribs is fixed on a side of the vertical part 532 adjacent to the horizontal part 531, and the sliding rib extends along the direction parallel to the horizontal part 531. For example, two first matching sliding ribs 507 are located on both sides of the locking base 509, two second matching sliding ribs 508 are located on both sides of the locking base 509, and two third matching sliding ribs 534 are located on both sides of the locking base 509, respectively. In one embodiment, one end of the first matching sliding rib 507, the second matching sliding rib 508 and the third matching sliding rib 534 is fixed on the vertical part 532, arranged sequentially along a direction from the side of the vertical part 532 away from the horizontal part 531 toward the horizontal part 531. The first matching sliding rib 507, the second matching sliding rib 508 and the third matching sliding rib 534 are parallel to each other and parallel to the horizontal part 531. In one embodiment, the length of the first matching sliding rib 507 is greater than the length of the second matching sliding rib 508 and smaller than the length of the third matching sliding rib 534.

Please refer to FIGS. 28 to 31 together. In some embodiments, the distance between the two first matching sliding ribs 507 is, for example, 20mm-50mm. In an embodiment, the distance between the two first matching sliding ribs 507 is 30mm-40mm, for example, 38.6mm. The distance between the two first matching sliding ribs 507 can be less than the distance between the two first sliding ribs 505. In some embodiments, the distance between the two second matching sliding ribs 508 is, for example, 30mm-60mm. In an embodiment, the distance between the two second matching sliding ribs 508 is 40mm-50mm, for example, 46.8 mm. The distance between the two second matching sliding ribs 508 can be smaller than the distance between the two second sliding ribs 506. In some embodiments, the distance between the first matching sliding rib 507 and the second matching sliding rib 508 is, for example, 1mm-5mm. In an embodiment, the distance between the first matching sliding rib 507 and the second matching sliding rib 508 is 2mm-4mm, for example, 2.8mm. The distance between the first matching sliding rib 507 and the second matching sliding ribs 508 can be smaller than the distance between the first sliding rib 505 and the second sliding rib 506. The distance between the second matching sliding rib 508 and the third matching sliding rib 534 is 2mm-8mm. In an embodiment, the distance between the second matching sliding rib 508 and the third matching sliding rib 534 is 3-7mm, for example, 3mm. The distance between the second matching sliding rib 508 and the third matching sliding rib 534 can be smaller than the distance between the second sliding rib 506 and the third sliding rib 518.

Please refer to FIG. 29. In some embodiments, a third protruding rib 535 may be provided on a side of the matching sliding rib adjacent to the button hole 533 along the extending direction of the matching sliding rib. The shape of the third protruding rib 535 is not specifically limited here. In some embodiments, the third protruding ribs 535 can be provided on one side of all the matching sliding ribs. In other embodiments, the third protruding ribs 535 can be provided on one side of some of the matching sliding ribs. In one embodiment, for example, the third protruding ribs 535 are provided on one side of the first matching sliding rib 507 adjacent to the button hole 533 in the extending direction of the first matching sliding rib 507 and are provided on one side of the second matching sliding rib 508 adjacent to the button hole 533 in the extending direction of the second matching sliding rib 508.

Referring to FIGS. 28 to 30, in some embodiments, the second locking unit 502 may also include a locking cover 513. The locking cover 513 and the vertical part 532 and the horizontal part 531 of the locking base 509 are combined to form a closed cavity. In an embodiment, both sides of the locking cover 513 are provided with slot structures 536 that fit the third protruding ribs 535 on the sides of the matching sliding ribs. The locking cover 513 is moved horizontally to insert the third protruding ribs 535 into the slot structures 536, and then the locking cover 513 is tightly coupled with the locking base 509. A locking hole 514 is provided on the side of the locking cover 513 away from the horizontal part 531 of the locking base 509.

Please refer to FIG. 28, FIG. 29 and FIG. 31. The locking member 530 includes a button 512, a tongue-shaped protrusion 516 and a locking block 504. The button 512 is sleeved in the button hole 533, allowing the button 512 to slide relative to the button hole 533. One end of the tongue-shaped protrusion 516 is connected to the side of the button 512 adjacent to the closed cavity, and the other end of the tongue-shaped protrusion 516 is arranged on the side of the locking hole 514 away from the vertical part 532. An inclination angle is formed between the tongue-shaped protrusion 516 and the horizontal direction away from the vertical part 532. The inclination angle ranges from 0 to 90°. In one embodiment, the inclination angle is, for example, 45°. In one embodiment, the other end surface of the tongue-shaped protrusion 516 is parallel to the vertical part 532. The locking block 504 is sleeved on the tongue-shaped protrusion 516, and the locking block 504 is arranged vertically. One end of the locking block 504 is aligned with the locking hole 514 and the end of the locking block 504 can be telescopic in the locking hole 514. The other end of the locking block 504 close to the locking hole 514 is provided with a slope to fit the locking groove 503 on the first locking unit 501. The button 512 slides relative to the button hole 533, driving the tongue-shaped protrusion 516 to move in the horizontal direction. Since the tongue-shaped protrusion 516 is inclined upward, the distance from the joint of the locking block 504 and the tongue-shaped protrusion 516 to the horizontal part 531 of the locking base 509 changes continuously, causing the end of the locking block 504 close to the locking hole 514 to stretch and contract in the locking hole 514, that is, the end of the locking block 504 close to the locking hole 514 is lower or higher than locking hole 514. When the end of the locking block 504 close to the locking hole 514 is higher than the locking hole 514, the locking block 504 at least partially exposes from the locking hole 514. The width of the locking block 504 is, for example, from 16mm to 25mm. In some embodiments, the distance from the locking block 504 to the vertical part 532 is 8mm-15mm. In an embodiment, the distance from the locking block 504 to the vertical part 532 is from 10mm to 13mm, for example 11.6mm. The thickness of the locking block 504 is, for example, from 2mm to 6mm. In an embodiment, the thickness of the locking block 504 is from 3mm to 5mm, for example, 4.4mm.

Please refer to FIG. 28, FIG. 29 and FIG. 31. In some embodiments, when the button 512 drives the tongue-shaped protrusion 516 to move closer to the button hole 533, the joint of the locking block 504 and the tongue-shaped protrusion 516 moves away from the horizontal part 531 of the locking base 509, the locking block 504 moves toward the direction of the locking hole 514, so that the locking block 504 exposes from the locking hole 514. When the button 512 drives the tongue-shaped protrusion 516 to move away from the button hole 533, the joint of the locking block 504 and the tongue-shaped protrusion 516 moves close to the horizontal part 531 of the locking base 509, and the locking block 504 moves away from the locking hole 514 so that the inclined end surface of the locking block 504 is flush with the plane where the locking hole 514 is located.

Please refer to FIGS. 28, 29, 31 to 33. In some embodiments, the second locking unit 502 also includes an elastic member (not shown), and the elastic member is provided on a side of the tongue-shaped protrusion 516 close to the horizontal part 531 of the locking base 509. The elastic member is connected between the button 512 and the locking cover 513, and the elastic force direction of the elastic member is parallel to the horizontal part 531 of the locking base 509. The elastic member is, for example, a spring. In one embodiment, the button 512 pulls or pushes the tongue-shaped protrusion 516 through the stretching or compression of the spring, so that the button 512 drives the tongue-shaped protrusion 516 to move closer to or away from the button hole 533.

Please refer to FIGS. 26 to 33. During use, when the locking member 530 is in an initial position, the second locking unit 502 moves along the first locking unit 501 in the horizontal direction. During the movement, the multiple sliding ribs in the first locking unit 501 are interspersed with the multiple matching sliding ribs in the second locking unit 502. When the inclined end surface of the locking block 504 contacts the bottom surface of the charging device 1, under a pressure action of the bottom surface of the charging device 1, the locking block 504 gradually moves away from the bottom surface of the charging device 1, and the joint between the locking block 504 and the tongue-shaped protrusion 516 approaches the horizontal part 531 of the locking base 509, and then drives the tongue-shaped protrusion 516 to move away from the side of the button hole 533. At this time, the elastic member gradually changes from the initial state to the compression state until the locking block 504 drops to a position flush with the plane of the locking hole 514. The second locking unit 502 and the first locking unit 501 continues to move relatively in the horizontal direction. When the end of the locking block 504 close to the locking hole 514 is aligned with the locking groove 503 on the bottom surface of the charging device 1, the pressure of the bottom surface of the charging device 1 exerted on the locking block 504 disappears. Then the elastic member gradually resets, that is, it returns from the compressed state to the initial state. The elastic member pushes the button 512 to slide toward the button hole 533. The movement of the button 512 drives the tongue-shaped protrusion 516 to move closer to the button hole 533. The joint between the locking block 504 and the tongue-shaped protrusion 516 gradually moves away from the direction of the horizontal part 531 of the locking base 509, and then the locking block 504 moves in the direction towards the locking hole 514 until the elastic member is reset, and the locking member 530 returns to its initial position. At this time, the locking block 504 exposes from the locking hole 514 and is inserted into the locking groove 503 to achieve fixed locking of the first locking unit 501 and the second locking unit 502. The multiple sliding ribs in the first locking unit 501 and the multiple matching sliding ribs in the second locking unit 502 are interspersed and matched, so that the locking structure 522 has good structural strength and small gaps, which avoids shake of the first locking unit 501 and the second locking unit 502 after being locked, which improves the stability and safety of the structure.

Referring to FIGS. 26 to 33, when the first locking unit 501 and the second locking unit 502 need to be unlocked and disengaged, the button 512 can be pressed, and the tongue-shaped protrusion 516 is driven by pressing the button 512 gradually to move away from the button hole 533, the elastic member gradually changes from the initial state to the compressed state, and the joint between the locking block 504 and the tongue-shaped protrusion 516 gradually approaches the horizontal part 531 of the locking base 509, and the locking block 504 gradually moves away from the locking hole 514, so that the locking block 504 drops to a position flush with the plane of the locking hole 514. Then, the first locking unit 501 and the second locking unit 502 are unlocked, the first locking unit 501 and the second locking unit 502 may be moved in opposite directions along the horizontal direction, so that the multiple sliding ribs in the first locking unit 501 and the multiple matching sliding ribs in the second locking unit 502 are disengaged, and then the first locking unit 501 and the second locking unit 502 are disengaged.

The disclosure also provides a variety of charging assemblies, as shown in FIGS. 2 and 7. The charging assemblies include a charging device 1 and an electronic device. In one embodiment of the disclosure, the electronic device is, for example, a common mobile phone, tablet or laptop computer. When charging, a smaller mobile phone can be placed in the receiving groove 134 (the tablet or laptop computer can be placed on a side of the charging device 1). A data cable can be used to connect the charging port of the mobile phone or tablet to the first terminal 203 to charge the electronic device, such as mobile phone or tablet.

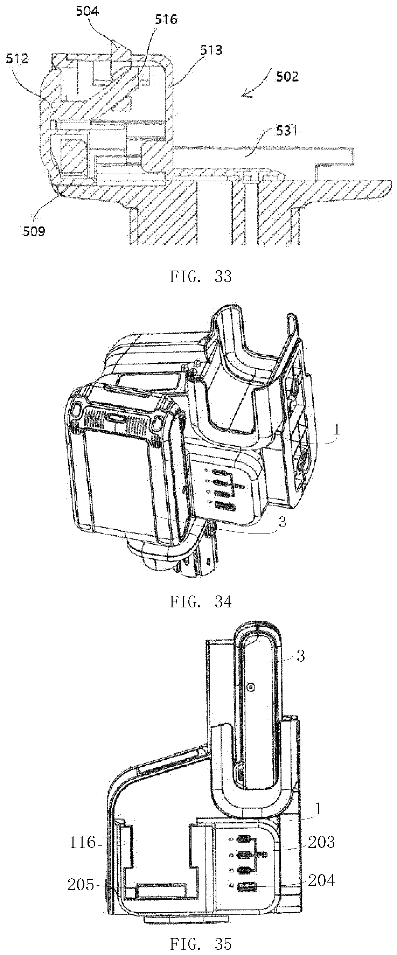

Referring to FIGS. 34 to 37, in another embodiment of the disclosure, the electronic device is, for example, a battery pack 3. The battery pack 3 has three ports, a first port 31, a second port 32 and a third port 33. The first port 31 and the second port 32 are type-c and/or USB ports, and the first terminal 203 and/or the second terminal 204 can charge or discharge the battery pack 3 through the first port 31 and the second charging port 33. The output portion 205 is matched with the third port 33, and can charge or discharge the battery pack 3 through the third port 33. A convex portion 34 is provided on the top surface of the battery pack 3, and two sliding grooves 35 are provided on two sides of the convex portion 34. The two sliding grooves 35 are arranged in parallel. The third port 33 is provided at one end of the convex portion 34 and is arranged between the sliding grooves 35 on both sides of the convex portion 34.

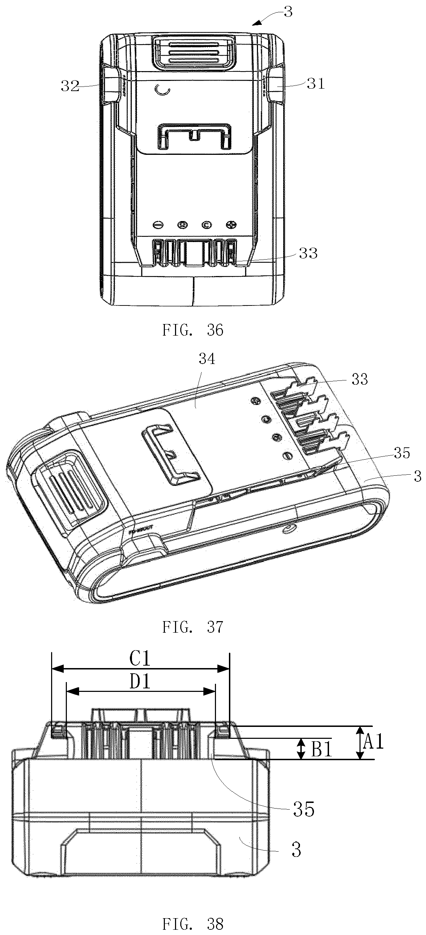

Please refer to FIGS. 36 to 37. Each port provided on the battery pack 3 provided by the disclosure includes the first port 31, the second port 32 and the third port 33 which can be charged independently; the first port 31 and the second port 32 can be charged at the same time; the third port 33 and the first port 31 can be charged at same time; and the third port 33 and the second port 32 can be charged at the same time.

Please refer to FIG. 34. The battery pack 3 is engaged with the first housing 110, and the battery pack 3 is fixed on the first housing 110. The sliding groove 35 is engaged with the guide rail 116. The output portion 205 is electrically connected to the third port 33 to charge or discharge the battery pack 3. At this time, the first port 31 or the second port 32 of the battery pack 3 can also be electrically connected to the first terminal 203 and/or the second terminal 204 through a data line to quickly charge or discharge battery pack 3. Please refer to FIG. 35. The battery pack 3 can also be clamped on the receiving groove 134. The first terminal 203 and/or the second terminal 204 are electrically connected to the first port 31 and/or the second port 32 through data lines, in order to charge or discharge battery pack 3.

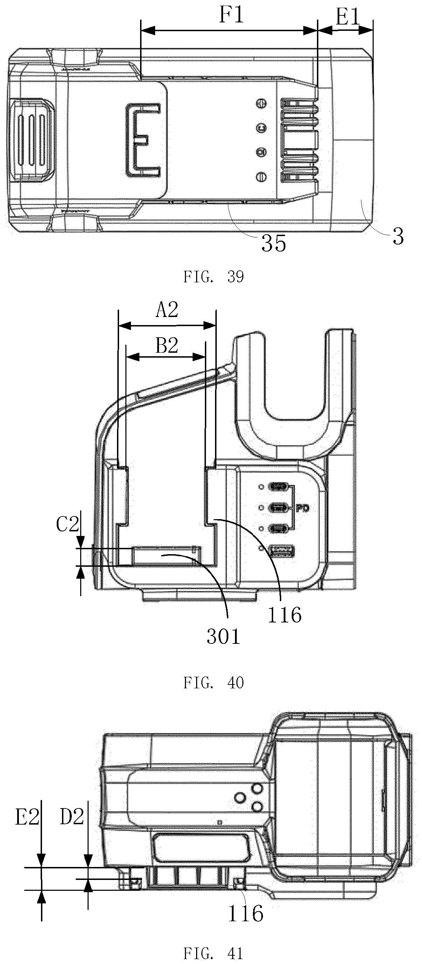

Referring to FIGS. 34 to 41, in order to ensure the engagement between the battery pack 3 and the charging device 1, the dimensions of the sliding groove 35 on the battery pack and the guide rail 116 on the charging device 1 are defined. The distance A2 between the inner guide rails of the two parallel guide rails 116 is adapted to the inner width D1 of the sliding groove 35, and the inner width D1 of the sliding groove 35 is slightly smaller than the distance A2 between the inner guide rails of the guide rail 116. In one embodiment, the inner width D1 of the sliding grooves 35 ranges from 45.8 mm to 46 mm, for example, and the distance A2 between the inner guide rails of the guide rails 116 ranges from 46.75 mm to 47 mm, for example. The distance B2 between the outer guide rails of the two parallel guide rails 116 is adapted to the outer width C1 of the sliding grooves 35, and the outer width C1 of the sliding grooves 35 is slightly smaller than the distance B2 between the outer guide rails of the guide rail 116. In one embodiment, the distance B2 between the outer guide rails of the guide rails 116 ranges from 55.9 mm to 56.1 mm, and the outer width C1 of the sliding grooves 35 ranges from 56.8 mm to 56 mm, for example. The thickness D2 of the inner guide rail of the guide rails 116 is adapted to the inner height A1 of the sliding groove 35. The thickness D2 of the inner guide rail of the guide rails 116 is slightly larger than and the inner height A1 of the sliding groove 35. In one embodiment, the thickness D2 of the inner guide rail of the guide rails 116 ranges from, for example, 5.8mm-6mm, and the range of the inner height A1 of the sliding groove 35 is, for example, 4.85mm-5.15mm. The thickness E2 of the outer guide rail of the guide rails 116 is adapted to the outer height B1 of the sliding groove 35, and the thickness E2 of the outer guide rail of the guide rails 116 is slightly greater than the outer height B1 of the sliding groove 35. In one embodiment, the thickness E2 of the outer guide rail of the guide rails 116 ranges from 11.85mm to 12.15mm, for example, and the outer height B1 of the sliding groove 35 ranges from 10.9mm to 10.1mm, for example.

Please refer to FIGS. 38 to 41. In one embodiment, the thickness C2 of the sliding part 301 on the charging device 1 is also defined. The thickness C2 of the sliding part 301 ranges from 9 mm to 11 mm, for example. The distance E1 from the sliding groove 35 to the front end of the battery pack 3 is also set. The distance E1 from the sliding groove 35 to the front end of the battery pack 3 ranges from 23mm to 23.2mm, for example. And the distance F1 from one end of the sliding groove 35 to the other end of the sliding groove 35 is set. The distance F1 from one end of the sliding groove 35 to the other end of the sliding groove 35 ranges from 73mm to 73.2mm, for example.

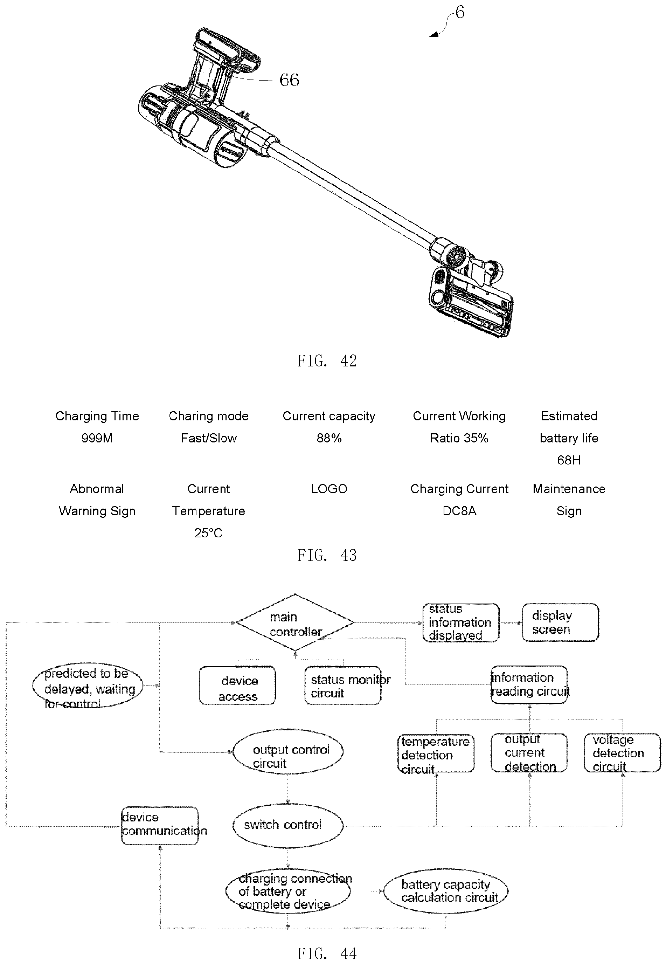

Referring to FIGS. 2 and 42, the electronic device is, for example, a vacuum cleaner 6. On the side of the vacuum cleaner 6 close to its battery pack 3, a fourth port 66 is provided, which matches the fourth terminal 206. When the vacuum cleaner 6 is fixed on the charging device 1, the fourth port 66 is electrically connected to the fourth terminal 206 to charge the vacuum cleaner 6.

Please refer to FIGS. 1 to 42. The disclosure provides a charging conversion device. Terminals are provided on different side surfaces of the charging device 1, and each terminal has different output voltages and different types, enabling charging of a variety of devices. A backboard mating part 401 is provided on the first housing 100 and the third housing 130, and a backboard body 400 is provided correspondingly to fix the charging device 1 on the side wall. A locking structure 522 is provided at the bottom of the charging device 1, that is, the locking structure 522 is provided on one side of the receiving groove 134. The locking structure 522 connects the charging device 1 to the fixed base 520, and fixes the charging device 1 on the fixed base 520, thereby realizing multiple fixed modes of the charging device 1.

As shown in FIG. 1, FIG. 43 to FIG. 44, the disclosure also provides a charging man-machine interaction system, including a charging module, a display module, and a detection module for obtaining charging information. The detection module is connected to the charging module, and the charging information includes at least one or a combination of battery capacity information, charging real-time status information, and charging prediction information. The input end of the display module is connected to the output end of the detection module. The charging information of one or more types of connected devices to be charged may be displayed through the display module. The charging module is, for example, the charging device 1 in the disclosure.

As shown in FIG. 43, In one embodiment, the display module includes a display screen that provides an output port between the system and the user. In some embodiments, the display screen may include a liquid crystal display (LCD) and a touch panel (TP). If the display screen includes a touch panel, the display screen may be implemented as a touch screen to receive input signals from the user. The touch panel includes one or more touch sensors to sense touches, swipes, and gestures on the touch panel. The touch sensor can not only sense the boundaries of a touch or swipe action, but also detect the duration and pressure associated with the touch or swipe action. The display screen can intuitively display the current status of the system and the entire machine. The displayed content includes but is not limited to temperature information, charging time, charging mode, abnormal warning signs, maintenance signs, current working ratio, estimated battery life, charging current, product LOGO and other information.

In one embodiment, a preprocessing module is also included. The preprocessing module includes: an identification unit, used to identify the device information of the accessed device to be charged, and the device information at least includes the type of the device to be charged; and an authority management module., The authority management module is configured to set the priority rule. The charging module performs charging the devices to be charged that are connected at the same time according to the charging priority specified in the priority rule. Through the identification unit, the current externally connected device to be charged can be identified. The device to be charged generally includes digital products, special battery products, and complete machines. The system can preset the charging priority according to the user's usage habits. When the system is connected to the above devices, the system will determine which device or which kind of device to charge according to the priority preset by different priority rules.

In an embodiment, the priority rules include:
a first priority rule, which is used to sort the charging sequence according to the initial voltage state of the battery when the device to be charged is connected; and/or,
a second priority rule, which is used to preset charging sequence of different devices to be charged.

In one embodiment, the charging information also includes the access time of the device to be charged, and the access time is obtained through the detection module. The authority management module is configured to pre-set a time control threshold. The charging module performs charging of a device that meets the first priority rule. When the charging time reaches the time control threshold, the device to be charged is charged according to the charging sequence of the second priority rule.

In one embodiment, through the first priority rule, the charging sequence can be sorted according to the initial voltage state of the battery when the device to be charged is connected. For example, the battery with the lowest voltage can be selected to start charging first according to the initial voltage state of each charged device. Through the time control threshold, the charging time can be controlled within a fixed time range. In some exemplary embodiments, after completing priority charging for a fixed period of time, the system can switch to charging in a predetermined secondary control mode, that is, using the second priority rule to charge the device. In some exemplary embodiments, when any device is re-plugged and connected during the charging process, the system will get a fixed priority charging authority.

In one embodiment, a man-machine interaction module is also included, through which the priority rules can be edited, and the editing content includes selecting the charging priority of the device to be charged. In one embodiment, the charging module includes several charging ports. The charging is performed by accessing the device to be charged to the charging port. The powers of the devices at each charging port are displayed through the display module. For example, the devices at the main dedicated charging ports can be displayed at the same time. Users can use this information to determine which device to be charged first through the man-machine interaction module. After selecting, the charging priority can be obtained by simply reconnection of the charged device to the system.

In one embodiment, an alarm module is also included, which is used to generate abnormal alarm information when the system fails and display the alarm information through the display module.

In one embodiment, the detection module may include a temperature detection circuit, an output current detection circuit, a voltage detection circuit, an information reading circuit, a status detection circuit, and a battery capacity calculation and detection circuit. The charging information also includes temperature information, charging time, current working ratio, estimated battery life, and charging current.

In one embodiment, the charging module includes a power supply assembly that provides power. The power supply assembly may include a power management system, one or more power supplies, and other components associated with generating, managing, and distributing power to terminal devices.

In one embodiment, a voice component is also included, and the voice component is configured to output and/or input a voice signal. For example, the voice component includes a microphone (MIC) configured to receive external voice signals when the system is in an operating mode, such as speech recognition mode. The received voice signals may be further stored in a memory or sent via a communication component. In some embodiments, the voice component also includes a speaker for outputting a voice signal, for example, broadcasting current charging information, device abnormality information, etc. through voice.

As shown in FIG. 44, in one embodiment, the detection module includes a temperature detection circuit, an output current detection circuit, a voltage detection circuit, an information reading circuit, a status detection circuit, a battery capacity calculation and detection circuit, etc. In one embodiment, the charging information also includes temperature information, charging time, charging mode, abnormal warning signs, maintenance signs, current working ratio, estimated battery life, charging current, product LOGO and other information.

In one embodiment, the detection module is mainly composed of a series of sensor components, which may include one or more sensors, and is used to provide various aspects of status assessment for the system. For example, the sensor component may detect the on/off status of the access device, the relative positioning of the components, the presence or absence of a touching action of user on the accessed device. The sensor component may also include a proximity sensor configured to detect the presence of nearby objects without any physical contact, including detecting the distance between the user and the device to be charged. In some embodiments, the detection module may also include a camera or the like.

In one embodiment, the communication component is configured to facilitate wired or wireless communication between the system and the device, or between the system and other devices. Wireless networks based on communication standards can be accessed, such as WiFi, 2G or 3G, or a combination thereof. In one embodiment, the electronic terminal device may include a SIM clamping member, which is used to insert a SIM card, so that the terminal device can log in to networks such as GPRS and 4G, and establish communication with a server for background management through the Internet.

A specific embodiment will be used for further explanation below:
as shown in FIG. 44, the charging man-machine interaction system in the embodiment includes a display screen, a main controller, a temperature detection circuit, an output current detection circuit, a voltage detection circuit, an information reading circuit, a status detection circuit, and a battery capacity calculation and detection circuit, output control circuit, and information reading circuit. When the device to be charged is connected to the system, the charging state is monitored through a status monitoring circuit, and information such as temperature, current, and voltage are read through the information reading circuit, and various status information during charging are displayed on the display screen. The output control circuit is used to control on/off of the connected device to be charged, such as the battery or the whole machine. Through the battery capacity calculation and detection circuit, the current working ratio, estimated battery life and other information are obtained, then fed back to the main controller through the communication component, and then displayed by the display screen.

The embodiment also provides a charging man-machine interaction display system. The difference of this system from the above-mentioned system is that the display system mainly includes: a display module, and a detection module for obtaining charging information. The charging information at least includes battery capacity information, charging real-time status information, and charging prediction information or a combination thereof. The input end of the display module is connected to the output end of the detection module, and the charging information of one or more connected devices to be charged is displayed through the display module.

In one embodiment, the device information of the connected device to be charged is displayed, and the device information at least includes the type of the device to be charged; according to the set priority rules, the device to be charged that is connected at the same time is charged and is displayed. The charging priority is specified in the priority rules.

In one embodiment, the charging real-time status information includes the voltage status of the battery, and the priority rules include:
a first priority rule, which is used to sort the charging sequence according to the initial voltage state of the battery when the device to be charged is connected; and/or,
a second priority rule, which is used to preset charging sequence of different devices to be charged.

In one embodiment, all charging information can be obtained through the interaction system. Correspondingly, the manner in which priority rules are formulated and how to perform charging operations can be performed through the manner in the above embodiments, and will not be described again here.

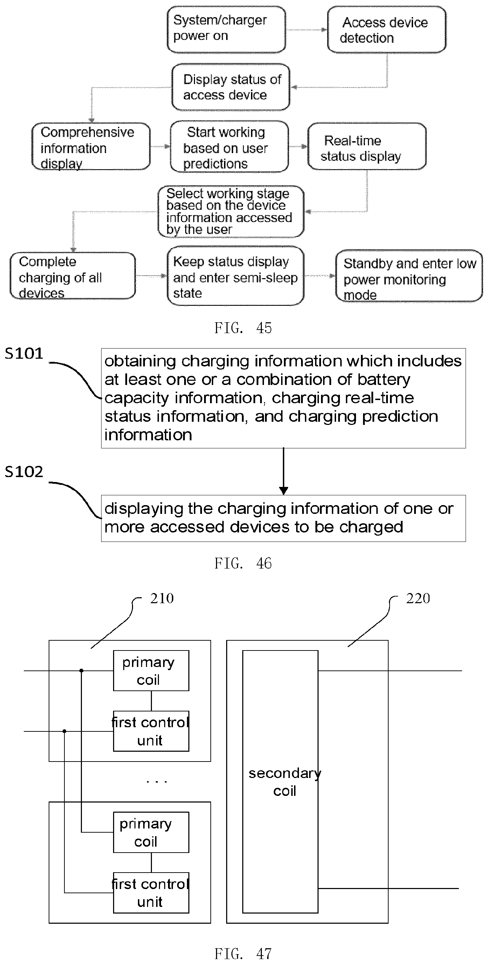

As shown in FIG. 46, the embodiment also provides a method of charging man-machine interaction, the method including:
S101. obtaining charging information, which includes at least one or a combination of battery capacity information, charging real-time status information, and charging prediction information;
S102. displaying the charging information of one or more accessed devices to be charged.

In one embodiment, the device information of the accessed device to be charged is identified, and the device information at least includes the type of the device to be charged.

The charging prediction information is obtained based on the type of device to be charged and current battery capacity information. The charging prediction information includes the operating time of the current power of the device and/or the operating content of the equipment;

Priority rules are set and the devices to be charged that are connected at the same time are charged according to the charging priority specified in the priority rules. The priority rules in the embodiment include:
a first priority rule, which is used to sort the charging sequence according to the charging real-time status information of the device to be charged when the device to be charged is connected, and the charging real-time status information includes the initial voltage status of the battery; and/or,
a second priority rules which is used to preset charging sequence of different devices to be charged.

In one embodiment, the method can be implemented in the same way as in the above-mentioned interaction system and display system. For example, the way in which priority rules are formulated and how to perform the charging operation can be carried out in the way in the above-mentioned system embodiment.

As shown in FIG. 45, in one embodiment, when all the devices to be charged complete charging, the charging information of the devices to be charged remains displayed and enters sleep mode, semi-sleep mode, low power consumption monitoring mode, etc.

In one embodiment, the device to be charged can be preset with one or more working modes. Of course, the charging mode can also include different charging methods such as fast charging and normal charging. The corresponding charging prediction information in each working mode is obtained according to the current battery capacity information of the device to be charged, and the corresponding charging prediction information is displayed according to the selected working mode. For example, taking a vacuum cleaner as an example, the charging prediction information can show the estimated working time based on the current status and battery capacity. The charging prediction information can also show how much work the vacuum cleaner can do, such as how many square meters of floor the vacuum cleaner is expected to clean. Charging prediction information allows users to make predictions about the use of device to be charged. However, conventional charging systems cannot give users a more accurate judgment through the above information, resulting in insufficient energy life when using the product, or. having to stop to replenish energy for the system after using it for a period of time, further resulting in insufficient work continuity experience and low work efficiency. The method in our embodiments can meet people's needs for intelligent and humanized charging.

Embodiments of the disclosure also provide an electronic terminal, which may include: one or more processors; and one or more machine-readable media with instructions stored thereon, which when executed by the one or more processors, the device is adapted to perform the methods described in FIGS. 45 and 46. In practical applications, the device can be used as a terminal device or a server. Examples of terminal devices can include: smartphones, tablets, e-book readers, MP3 (Moving Picture Experts Group Audio Layer III) player, MP4 (Moving Picture Experts Group Audio Layer IV) player, laptop computer, vehicle computer, desktop computer, set-top box, smart TV, wearable device etc., the embodiments of the disclosure do not limit specific equipment.

Embodiments of the disclosure also provide a non-volatile readable storage medium. One or more modules (programs) are stored in the storage medium. When the one or more programs are applied to a device, the device is adapted to execute instructions for the steps included in the data processing method in FIG. 45 of the embodiment of the disclosure. The processor can be a central processing unit (CPU), application specific integrated circuit (ASIC), digital signal processor (DSP), digital signal processing device (DSPD), programmable logic device (PLD), field programmable gate array (FPGA), controller, microcontroller, microprocessor or other electronic element, the processor may include random access memory (RAM), and may also include non-volatile memory (non-volatile memory), such as at least one disk storage. The processor is coupled to input devices and output devices through wired or wireless connections.

In some exemplary embodiments, the device port can be a wired port for data transmission between devices, or a hardware plug-in port (such as a USB port, serial port, etc.) for data transmission between devices; optional, the user port may be, for example, a user-oriented control button, a voice input device for receiving voice input, and a touch sensing device to receive user touch input (such as a touch screen, touch pad, etc. with a touch sensing function); optional a programmable port of the above-mentioned software may be, for example, an entrance for the user to edit or modify the program, such as the input pin port or input port of the chip, etc.

The disclosure may be used in computing system in numerous general purposes or special purpose environments or configurations. For example: personal computers, server computers, handheld or portable devices, tablet devices, multiprocessor systems, microprocessor-based systems, set-top boxes, programmable consumer electronics devices, network PCs, minicomputers, mainframe computers, and including distributed computing environment for any of the above systems or devices, etc.

The disclosure may be described in the general context of computer-executable instructions being executed by a computer, such as program modules. Generally, program modules include routines, programs, objects, components, data structures, etc. that perform specific tasks or implement specific abstract data types. The disclosure may also be practiced in distributed computing environments where tasks are performed by remote processing devices connected through a communications network. In a distributed computing environment, program modules may be stored in both local and remote computer storage media including storage devices.

Please refer to FIG. 1 and FIG. 47. The disclosure provides a drive control circuit, and the drive control circuit is, for example, provided on the circuit board of the charging device 1, and is used to control the charging device 1 to charge/discharge electronic device, or to charge the circuit board. In some embodiments, the drive control circuit includes: a plurality of converter modules 210 and an output module 220.

Each of the plurality of the converter modules 210 includes a primary coil and a first control unit. The output terminal of the primary coil is connected to the first control unit. The input terminal of the primary coil is used to receive a drive signal, and two adjacent converter modules 210 are connected in parallel. For example, the number of converter modules 210 can be set to 2, 3, ..., n, n≥2 and n is positive integer. Without changing the structure of the drive control circuit and adding additional components, multiple primary coils are added to store more energy. When each of the primary coils needs to release energy to the outside, the output power of the primary coil to the outside will be increased.

The output module 220 includes a secondary coil. Each of the primary coils is matched with the secondary coil. When output power is required to be driven, the input terminal of the primary coil is connected to the drive signal. The first control unit controls the output terminal of the primary coil to be conducted. When the primary coil completes energy storage, the first control unit controls the output terminal of the primary coil to be disconnected. At this time, the magnetic induction intensity of the primary coil changes, thereby stimulating the secondary coil to complete energy conversion. After completing the energy conversion, the secondary coil outputs power to the outside, and saves more energy by connecting multiple primary coils in parallel, thereby achieving the purpose of increasing the output power of the secondary coil without adding redundant components and effectively reducing costs.

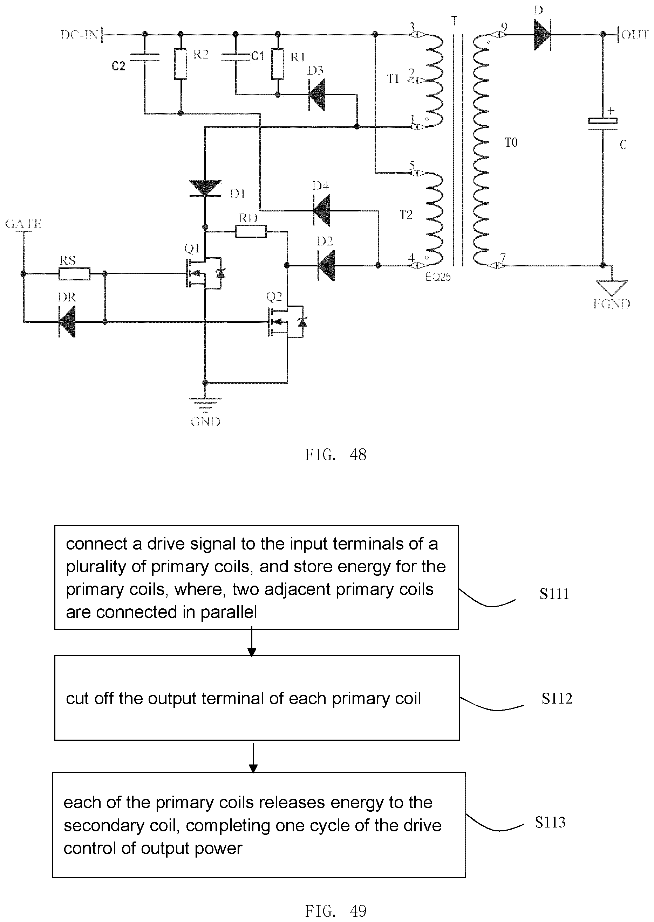

Please refer to FIG. 48. The disclosure also provides an implementation scheme of a drive control circuit. This embodiment uses two converter modules as an example. During the implementation process, it can be determined according to specific product requirements and actual working conditions to select the number of converter modules/primary coils. For example, the drive control circuit includes three converter modules/primary coils. For example, the drive control circuit includes four or more converter modules/primary coils. Refer to FIG. 48, the drive signal is input through DC-IN. Since the primary coils T1 and T2 are set in parallel, and the input terminals of the primary coils T1 and T2 are connected to the drive signal, the first controller Q1 and Q2 respectively conduct the output ends of the primary coils T1 and T2, therefore, the primary coils T1 and T2 form a path and store energy in the primary coils T1 and T2. When the primary coils T1 and T2 store energy, the electrical energy of the drive signal will be converted to electromagnetic energy. When the primary coils T1 and T2 complete energy storage, the first controllers Q1 and Q2 perform circuit-breaking control on the output terminals of the primary coils T1 and T2 respectively. At this time, electromagnetic energy stored by the primary coils T1 and T2 attenuates and changes, and then the primary coils T1 and T2 convert the electromagnetic energy into electrical energy with the secondary coil T0, and finally the drive control of output power in one cycle is completed. Because when the drive circuit is connected, the total resultant impedance in the drive control circuit is low, so the heat loss is correspondingly small. At the same time, the temperature rise caused by the resistance loss will also be reduced. For example, temperature rise can be reduced by about 30%.

Please refer to FIG. 48. In order to provide over-current protection to the output terminals of the primary coils T1 and T2, and in order to absorb the reverse peak voltage when the output terminals of the primary coils T1 and T2 are cut off, the converter module also includes a first diode, the input terminal of the first diode is connected to the output terminal of the primary coil, and the output terminal of the first diode is connected to the first control unit. For example, a first diode D1 is provided at the output terminal of the primary coil T1, the input terminal of the first diode D1 is connected to the output terminal of the primary coil T1, and the output terminal of the first diode D1 is connected to the first controller Q1. A first diode D2 is set at the output terminal of the primary coil T2, the input terminal of the first diode D2 is connected to the output terminal of the primary coil T2, and the output end first diode D2 is connected to the first controller Q2. At the same time, the first diode D1 and the first diode D2 can also be set as isolation diodes, and interference problem caused by the difference between the primary coils T1 and T2 can also be eliminated. By arranging two primary coils T1 and T2 in parallel, the output power can be increased by 45% to 64%, and the cost will only increase by about 5%, which has good product performance and cost advantages.

Please refer to FIG. 48. In order to further absorb the reverse peak voltage when the output terminals of the primary coils T1 and T2 are disconnected, an RC circuit unit is provided between the input terminal and the output terminal of the primary coil. This avoids the instantaneous reverse peak voltage caused by the primary coil being cut off, and also avoids the breakdown effect on the entire drive control circuit.

Please refer to FIG. 48. In order to prevent the RC circuit unit from absorbing too much energy stored in the primary coil and to avoid reducing the output power of the driver, the RC circuit unit includes a first resistor, a first capacitor and a second diode. The first resistor and the first capacitor are connected in parallel, and the first resistor and the first capacitor are both connected in series with the output terminal of the second diode, and the input terminal of the second diode is connected to the output terminal of the primary coil. For example, in a first converter module, the RC circuit unit includes a first resistor R1, a first capacitor C1 and a second diode D3. When the primary coil T1 completes energy storage and the output end is turned off, the primary coil T1 releases energy to the secondary coil T0, and the second diode D3 conducts the released energy in one-way direction. The first diode D1, the first resistor R1, and the first capacitor C1 absorb the reverse peak voltage. For example, in a second converter module, the RC circuit unit includes the first resistor R2, the first capacitor C2 and the second diode D4. When the primary coil T2 completes energy storage and the output terminal is cut off, the primary coil T2 releases energy to the secondary coil T0, the second diode D4 conducts the released energy in one-way direction, the first diode D2, the first resistor R2, and the first capacitor C2 absorb the reverse peak voltage. Then the primary coil T1 and the primary coil T2 simultaneously releases energy to the secondary coil T0 and completes a cycle of output power drive control.

Please refer to FIG. 48. In order to balance the response sequence between two adjacent converter modules and adjust the difference in output power, the drive control circuit also includes a second resistor. The second resistor is connected to output ends of the adjacent two the primary coils respectively. For example, a second resistor RD can be arranged between the output ends of the primary coil T1 and the primary coil T2. For another example, one end of the second resistor RD is arranged between the output terminal of the first diode D1 and the first controller Q1, the other end of the second resistor RD is arranged between the output terminal of the first diode D2 and the first controller Q2.

In order to facilitate the signal control of the first control unit and the conduction and disconnection of the output terminal of the primary coil, the first control unit includes at least one of the following: a field effect transistor, a relay, and a transfer switch. For example, the field effect transistor can be a MOSFET (Metal-Oxide-Semiconductor Field-Effect Transistor). For another example, the control unit includes a signal input terminal, a signal output terminal and a signal control terminal. The signal input terminal is connected to the output terminal of the secondary coil, and the signal output terminal is connected to the ground wire of the converter module. The signal control terminal is used to receive the control signal. For example, the signal input terminal and the signal output terminal may be the source or drain of a field effect transistor, and the signal control terminal may be the gate of the field effect transistor. A control signal can be applied to the gate of the field effect transistor to achieve a conduction between the source and drain, a control signal can also be applied to the gate of the field effect transistor to achieve cutoff or disconnection between the source and drain. For example, the signal input terminal and the signal output terminal may be the input terminal and the output terminal of a normally closed relay. The control signal controls the closing and opening of the signal control terminal of the normally closed relay to control the conduction and disconnection of the primary coil. For another example, the first control unit can also be a normally closed transfer switch. When the primary coil needs to store energy, the output terminal of the primary coil is turned on. When the primary coil needs to release energy to the secondary coil, the output terminal of the primary coil can be turned off through switching the first control unit from normally closed to normally open.

Please refer to FIG. 48. In order to control the control signal, the converter module also includes a second control unit. The second control unit includes a control signal input terminal GATE, a third resistor RS and a fourth diode DR, and the third resistor RS are respectively connected in series with each of the signal control terminals. For example, the third resistor RS is connected in series with the signal control terminal of the first controller Q1 and the third resistor RS is connected in series with the signal control terminal of the first controller Q2. The input terminal of the fourth diode DR is connected to each of the signal control terminals, and the output terminal of the fourth diode DR is connected to the control signal input terminal GATE.

Please refer to FIG. 48. In order to prevent the secondary coil from generating a reverse voltage to the primary coil, the output module also includes a third diode D and a second capacitor C. The input terminal of the third diode D is connected to the secondary coil T0, the output terminal of the third diode D is connected to the output terminal OUT of the output module, and the second capacitor C is respectively connected to the output terminal of the third diode D and the ground wire FGND of the output module.

Please refer to FIG. 49. The disclosure also provides a drive control method, and the method includes operations S111, S112 and S113.

S111: Connect a drive signal to the input terminals of a plurality of primary coils, and store energy for the primary coils. The energy storage process of each primary coil is: the electric energy of the drive signal converts to the electromagnetic energy of the primary coil. In the process of energy conversion, two adjacent primary coils are connected in parallel, and the stimulus of the drive signal can be received through the parallel arrangement of the plurality of the primary coils, thereby completing energy storage in the primary coils. Energy storage stored in the primary coils can be increased without changing the circuit structure and adding redundant components, and the output power can be increased when the primary coil releases energy to the secondary coil.

S112: When each of the primary coils completes energy storage, the output terminal of each of the primary coils is disconnected. At this time, the electromagnetic energy stored in each of the primary coils gradually decays.

S113: The primary coils during decaying excites the secondary coil, and the conversion of electromagnetic energy into electrical energy and power output are occurred in the secondary coil. Each of the primary coils releases energy to the secondary coil, completing one cycle of the drive control of output power. The output power which is generated by driving of released energy from parallel-connected primary coils to the secondary coil is increased.

In order to facilitate the control of the output terminal of each primary coil and satisfy the drive control of energy storage and energy release of each parallel primary coil, on/off of the output terminal of each primary coil is controlled through a first control unit.

In some implementations, the first control unit includes at least one of the following: a field effect transistor, a relay, and a transfer switch. For example, the field effect transistor can be a MOSFET (Metal-Oxide-Semiconductor Field-Effect Transistor). For another example, the control unit includes a signal input terminal, a signal output terminal and a signal control terminal. The signal input terminal is connected to the output terminal of the secondary coil, and the signal output terminal is connected to the ground wire of the converter module. The signal control terminal is used to receive the control signal. For example, the signal input terminal and the signal output terminal may be the source or drain of a field effect transistor, and the signal control terminal may be the gate of the field effect transistor. A control signal can be applied to the gate of the field effect transistor to achieve a conduction between the source and drain, a control signal can also be applied to the gate of the field effect transistor to achieve cutoff or disconnection between the source and drain. For example, the signal input terminal and the signal output terminal may be the input terminal and the output terminal of a normally closed relay. The control signal controls the closing and opening of the signal control terminal of the normally closed relay to control the conduction and disconnection of the primary coil. For another example, the first control unit can also be a normally closed transfer switch. When the primary coil needs to store energy, the output terminal of the primary coil is turned on. When the primary coil needs to release energy to the secondary coil, the output terminal of the primary coil can be turned off through switching the first control unit from normally closed to normally open.

In order to further control the response of the signal control terminal, the control signal is generated by a second control unit to control the signal control terminal. The second control unit includes a control signal input terminal, a third resistor and a fourth diode. The third resistor is connected in series with each of the signal control terminals respectively, the input terminal of the fourth diode is connected with each of the signal control terminals, and the output terminal of the fourth diode is connected to the control signal input terminal.

In order to further absorb the reverse peak voltage when the output terminal of each primary coil is disconnected, an RC circuit unit is provided between the input end and the output terminal of the primary coil. When primary coils releases energy to the secondary coil, the RC circuit unit absorbs the voltage signal released by the secondary coil.

In order to prevent the RC circuit unit from absorbing too much energy stored in the primary coil and to avoid reducing the output power of the driver, the RC circuit unit includes a first resistor, a first capacitor and a second diode. The first resistor and the first capacitor are connected in parallel, and the first resistor and the first capacitor are both connected in series with the output terminal of the second diode, and the input terminal of the second diode is connected to the output terminal of the primary coil.

In order to balance the response sequence between two adjacent converter modules and adjust the difference in output power, a second resistor is provided to balance the sequence between two adjacent primary coils. The second resistor is connected to the output terminals of the two adjacent primary coils.

In order to prevent the secondary coil from generating a reverse voltage to the primary coil, a first diode is arranged to conduct the output terminal of the primary coil in one-way, and the input terminal of the first diode is connected to the output terminal of the first control unit.

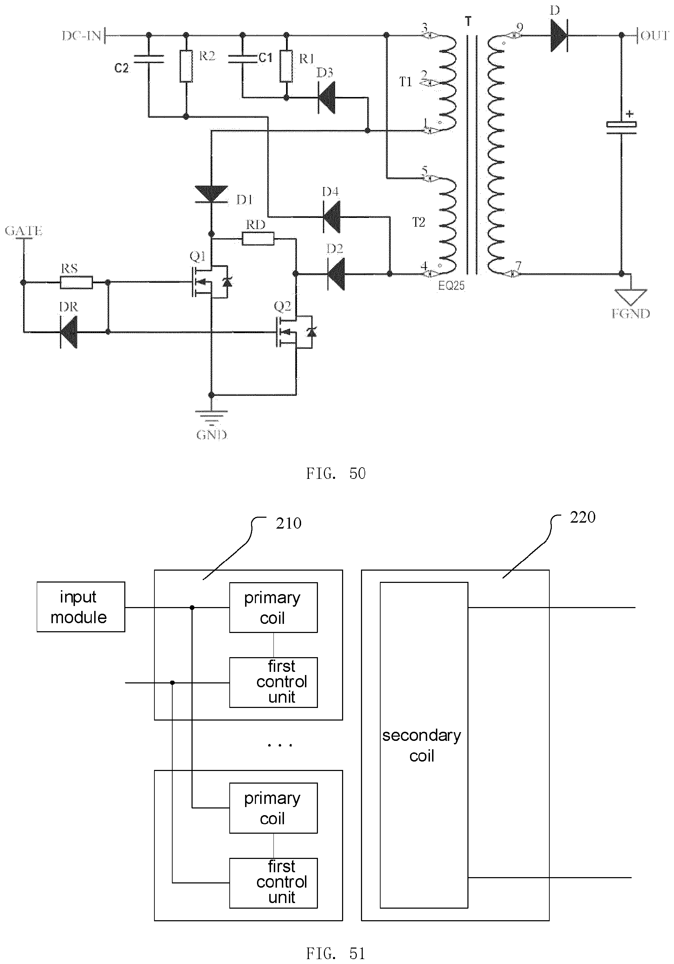

Please refer to FIGS. 50 and 51. The disclosure provides a drive control method for drive control of energy storage and release of two parallel primary coils. This embodiment uses two primary coils as an example. During the implementation process, the number of primary coils can be selected based on specific product requirements and actual working conditions. For example, drive control of 3 parallel primary coils, or for example, drive control of 4 or more than 4 parallel primary coils.

Please refer to FIG. 50. The signal flow direction in one of the primary coils T1 is:
S10: drive signal is accessed to DC-IN;
S20: the primary coil T1 is excited and turned on;
S30: the first diode D1 is conducted in one-way direction;
S40: the first controller Q1 is turned on;
S50: the negative terminal GND is turned on;
S60: the primary coil T1 completes energy storage;
S70: the first controller Q1 is turned off;
S80: the primary coil T1 releases energy to the secondary coil T0;
S90: the first diode D1, the first resistor R1, and the first capacitor C1 absorb the reverse peak voltage;
S100: one cycle of drive control of output power is completed.
In the same way: the signal flow direction in the other primary coil T2 is:
S11: drive signal is accessed to DC-IN;
S21: the primary coil T2 is excited and turned on;
S31: the first diode D2 is conducted in one-way direction;
S41: the first controller Q2 is turned on;
S51: the negative terminal GND is turned on;
S61: the primary coil T2 completes energy storage;
S71: the first controller Q2 is turned off;
S81: the primary coil T2 releases energy to the secondary coil T0;
S91: the first diode D2, the first resistor R2, and the first capacitor C2 absorb the reverse peak voltage;
S101: one cycle of drive control of output power is completed.

The output power of the secondary coil T0 is driven and controlled through the primary coils T1 and T2, in order to increase the output power.

Please refer to FIG. 51. The disclosure also provides another drive control device, and the device includes: a plurality of converter modules 210, an input module, and an output module 220.

Each of the plurality of the converter modules 210 includes a primary coil and a first control unit. The output terminal of the primary coil is connected to the first control unit. The input terminal of the primary coil is used to receive a drive signal, and two adjacent converter modules 210 are connected in parallel.

**The** input module is used to output the drive signal, and the output end of the input module is connected to the input terminal of the primary coil.

The output module 220 includes a secondary coil. Each of the primary coils is coupled with the secondary coil. When output power is required to be driven, the input terminal of the primary coil is connected to the drive signal through the input module. The first control unit controls the output terminal of the primary coil to be conducted. When the primary coil completes energy storage, the first control unit controls the output terminal of the primary coil to be disconnected. At this time, the magnetic induction intensity of the primary coil changes, thereby stimulating the secondary coil to complete energy conversion. Connecting multiple primary coils in parallel may save more energy and achieve the purpose of increasing the output power of the secondary coil without adding redundant components.

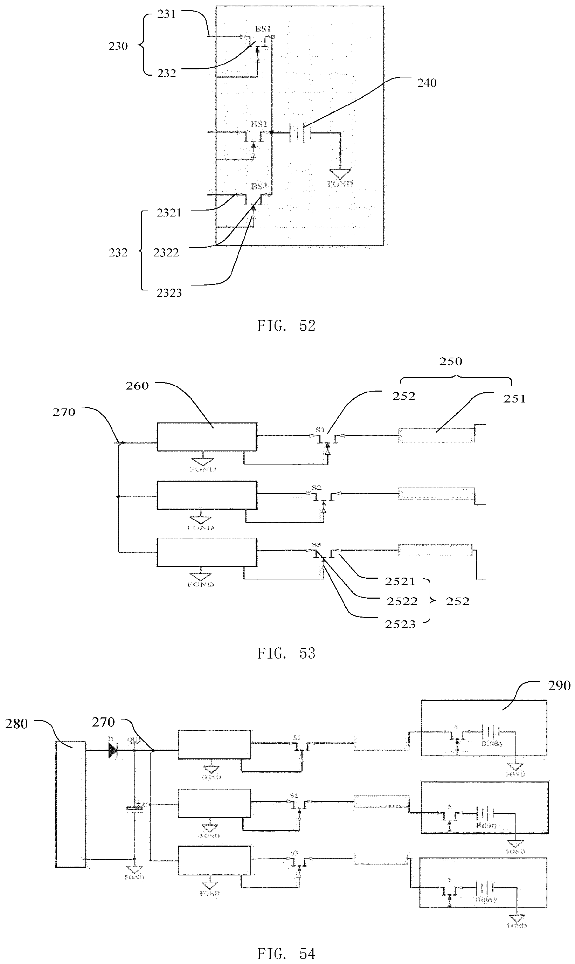

Referring to FIG. 52, the disclosure provides a rechargeable battery. The rechargeable battery is, for example, a battery pack, and the rechargeable battery includes: a plurality of first port circuits 230 and an energy module 240.

Each of the first port circuits 230 includes a first electrical signal port 231 and a first protection switch 232. The first electrical signal port 231 and the first protection switch 232 are in series connection, and two adjacent first port circuits 230 are in parallel connection. For example, the number of first port circuits 230 includes 2, 3, 4, ..., n, n≥2. The plurality of first port circuits 230 achieves an input solution having multi-charging channel for the rechargeable battery and shunts the charging current, which can not only increase the charging current and charging power, improve the charging speed of the rechargeable battery, but also reduce the temperature rise of a single protection switch during the charging process, thus avoiding excessive internal temperature of the rechargeable battery generated by large charging current and charging power, and improving the charging safety of the rechargeable battery.

Each of the first port circuits 230 is connected in series with the energy module 240. The energy module 240 may include a battery unit which can be repeatedly charged/discharged. For example, the battery unit may include at least one of the following: nickel cadmium battery, nickel metal hydride battery, lithium ion battery, lead battery, and lithium iron battery. Since the rechargeable battery includes the plurality of the first port circuits 230, the type and quantity of chargers for rechargeable battery can be selected according to the number and type of a charger, remaining battery capacity of the rechargeable battery, the expected charging time of the rechargeable battery, etc. The application scenarios are relatively wide and can be used to charge 3C electronic products, such as: mobile phones, tablets, laptops, digital cameras, rechargeable electric shavers, etc., charge other electronic products that use 5V, 9V, 12V, 15V, and 20V voltage platforms for charging, and charge garden tools, power tools, and household cleaning tools.

Please refer to FIG. 52. In some implementations, the first electrical signal port 231 includes a standard charging protocol port, and the standard charging protocol port includes a serial bus port, such as a standard USB (Universal Serial Bus) port, mini-USB port, micro-USB port, and for example, other USB ports, such as Type-C port, Type-C1 port, Lighting port, or wire port. By arranging different types of ports, it is possible to wide options for selecting a charger for charging the rechargeable battery, avoiding that the rechargeable battery can only be adapted to a single standard charging protocol port, and solving the problem of difficulty in charging the rechargeable battery. At the same time, the rechargeable battery provides multiple and/or multiple types of the first electrical signal port which can charge the rechargeable battery at the same time to improve the charging efficiency. Each of the first port circuits 230 is provided with a first protection switch 232, which can respectively protect the rechargeable battery and avoid overcurrent or overload, and also avoid excessive concentration of thermal stress inside the rechargeable battery.

Please refer to FIG. 52. In order to realize the turn-on, turn-off, over-current protection and over-load protection of the first port circuit 230, the first protection switch 232 includes a first input terminal 2321, a first input terminal 2322 and a first control terminal 2323. The rechargeable battery also includes a first control unit for generating a first control signal. The first control unit may be a key control. For example, when the first port circuit 230 receives a charging signal, a key is pressed, then the key control is realized through a transfer switch. The key control acts on the first control terminal 2323. The key signal is the first control signal. The first control unit is connected to the first control terminal 2323, and the first control unit controls the first control signal to turn on or turn off the first input terminal 2321 and the first input terminal 2322. For example, the first control unit can be configured as a field effect transistor, or a can be a metal-oxide-semiconductor field-effect transistor/MOSFET. When the first port circuit 230 receives the charging signal, the first control unit responds, and the first control unit outputs the first control signal to the gate of the field-effect transistor or MOSFET. When the gate receives the first control signal, the first input terminal 2321 and the first input terminal 2322 are turned on, and the first input terminal 2321 and the first input terminal 2322 are turned on; for another example, the first control unit can be provided as a relay, and the conduction state of the first control terminal 2323 is controlled by the relay, so as to turn on or turn off the first input terminal 2321 and the first input terminal 2322. Similarly, when the energy module 240 completes charging, the first input terminal 2321 and the first input terminal 2322 may be turned off through the first control unit, thereby avoiding potential safety hazards and energy waste caused by the continuous charging of the energy module 240.

Please refer to FIGS. 1 and 53. Corresponding to the rechargeable battery provided in FIG. 52, the disclosure also provides a charging control circuit, and the charging control circuit is, for example, arranged on the circuit board of the charging device 1, and the charging control circuit includes a plurality of second port circuits 250, a conversion module 260, and a power supply input port 270.

Each of the second port circuits 250 includes a second electrical signal port 251 and a second protection switch 252. The second electrical signal port 251 and the second protection switch 252 are in series connection, two adjacent second port circuits 250 are in parallel connection. For example, the number of second port circuits 250 includes 2, 3, 4, ..., n, n≥2. The plurality of second port circuits 250 provides an input solution having multi-charging channel for the rechargeable battery, which can not only increase the charging current and charging power, improve the charging speed of the rechargeable battery, or increase the type and quantity of charging device connected to the charging control circuit, but also reduce the temperature rise of a single protection switch during the charging process, thus avoiding large temperature rise of the charging control circuit caused by large charging current and charging power.

**The** conversion module 260 couples the second port circuit 250. The conversion module 260 is connected to the second port circuit 250 and converts the received power supply signal through the conversion module, for example, converts output current and output power. The power supply signal converted by the conversion module can meet the output voltage, output current or output power requirements of the second electrical signal port 251.

**The** power supply input port 270 is configured to receive the power supply signal. The power supply input port 270 is connected in series with each of the second port circuits 250. The charging control circuit can provide an output solution having multi-charging channel, and can provide multiple and/or multiple types of charging output ports in one circuit design, that is, multiple and/or multiple types of second electrical signal ports 251 are provided. During charging process, different charging devices can be connected to corresponding second electrical signal port 251, the second electrical signal port 251 can also be connected to the rechargeable battery with multiple charging channels at the same time for charging, so as to avoid excessive current and power caused by the charging control circuit of a single charging channel, thus avoiding high temperature rise of the charging control circuit. The charging control circuit can charge different types of electrical equipment and meet charging needs of electrical equipment in different scenarios. For example, it can meet the power needs of household appliances, electronic devices, garden tools, or power tools.

Please refer to FIG. 53. In order to realize the turn-on, turn-off, over-current protection and over-load protection of the second port circuit 250, the second protection switch 252 includes a second input terminal 2522, a second output terminal 2521 and a second control terminal 2523. The conversion module 260 also includes a second control unit for generating a second control signal. The second control unit is connected to the second control terminal 2523 and controls the second control signal to turn on or turn off the second input terminal 2522 and the second output terminal 2521.

For example, when the second port circuit 250 is connected to the power supply signal and performs key control, the key control can be realized by switching the transfer switch. The key control acts on the second control terminal 2523, and the key signal is the second control signal. The second control unit is connected to the second control terminal 2523, and the second control unit controls the second control signal to turn on or turn off the second input terminal 2522 and the second output terminal 2521. For example, the second control unit may be configured as a field effect transistor or a MOSFET. When the second port circuit 250 receives the power supply signal, the second control unit responds, and the second control unit outputs a second control signal to the gate of the field effect transistor or MOSFET. When the gate receives the second control signal, the second input terminal 2522 and the second output terminal 2521 are turned on. For another example, the second control unit can be set as a relay, and the conduction state of the second control terminal 2523 is controlled through the relay, so as to turn on or turn off the second input terminal 2522 and the second output terminal 2521. Similarly, when the charging equipment completes charging, the second input terminal 2522 and the second output terminal 2521 may be cut off though the second control unit, thereby avoiding potential safety hazards and energy waste caused by the charging equipment.

Please refer to FIG. 53. In some implementations, the second electrical signal port 251 includes a standard charging protocol port, and the standard charging protocol port includes a serial bus port, such as a USB port, a mini-USB port, Micro-USB port, Type-C port, Type-C1 port or wire port. By arranging different types of ports, it is possible to wide options for charging the electrical equipment, avoiding that the charging control circuit can only be adapted to a single standard charging protocol port, leading to the problem that the charging control circuit cannot match the electrical equipment. At the same time, the charging control circuit provides multiple and/or multiple types of second electrical signal ports, which can simultaneously charge multiple and/or multiple types of electrical devices to improve charging efficiency. Each second port circuit 250 is provided with a second protection switch 252, which can respectively protect the second port circuit on the corresponding channel to avoid overcurrent or overload, and to avoid excessive concentration of thermal stress inside the charging control circuit.

Please refer to FIG. 54. The disclosure also provides a charging control device, including: the charging control circuit and a power supply module 280. The power supply module 280 is connected to the charging control circuit. The power supply module 280 performs AD conversion and voltage conversion on the alternating current, the power supply module 280 is connected to the power supply input port 270, and connected to the electrical equipment 290 through the conversion and port of the charging control circuit, which can provide multiple and/or multiple types of electrical equipment 290 at the same time. The charging control device meets the power needs of multiple and/or multiple types of electrical equipments290, which can meet the power needs of household appliances, electronic device, garden equipment, or power tools.

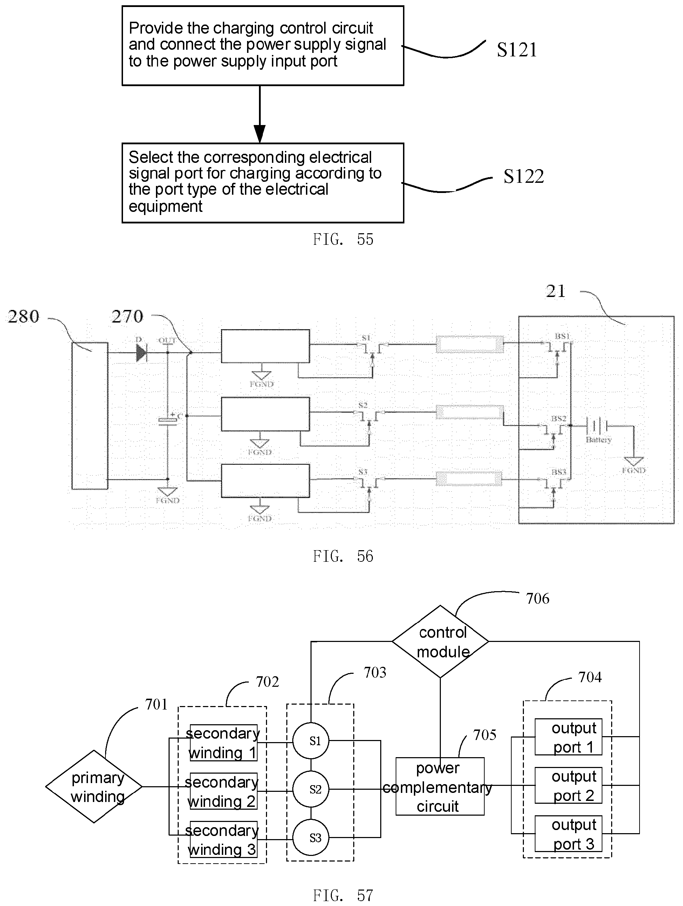

Please refer to FIG. 55. The disclosure provides a charging control method, including operations S121 and S122.

S121: Provide the charging control circuit and connect the power supply signal to the power supply input port.

S122: Select the corresponding electrical signal port for charging according to the port type of the electrical equipment. The multi-charging channel output solution can provide multiple and/or multiple types of second port circuits, and the second port circuits can match multiple and/or multiple types of electrical equipments, or multiple and/or multiple types of second port circuits can charge one electrical device or rechargeable battery at the same time, which provides more possible solutions for charging electrical equipment, and can also charge through multiple The channel charges an electrical device or rechargeable battery at the same time, improving charging efficiency and speed.

Please refer to FIG. 56, which is a schematic diagram of charging a rechargeable battery. The disclosure also provides a charging control method, including:
providing a rechargeable battery 21. The rechargeable battery 21 includes a plurality of first port circuits and an energy module. Each of the first port circuits includes a first electrical signal port and a first protection switch. The first electrical signal port is connected in series with the first protection switch, two adjacent first port circuits are connected in parallel, and each of the first port circuits is connected in series with the energy module.
providing a charging control circuit. The charging control circuit includes: a second port circuit coupled with the first port circuit, a conversion module coupled with the second port circuit, the conversion module and the third port circuit being connected, and a power supply input port 270 configured to receive a power supply signal. The power supply input port 270 is connected in series with each of the second port circuits.
connecting the power supply signal to the power supply input port 270 through the power supply module 280, and connecting at least one of the first port circuits to the corresponding second port circuit through the first electrical signal port to charge the rechargeable battery21. For example, if the rechargeable battery 21 has sufficient power and there is no strong urgency to use the rechargeable battery 21, part of the first port circuits can be selected to couple the second port circuit for charging. For example, if the rechargeable battery 21 has insufficient power, and there is a strong urgency to use the rechargeable battery 21, all the first port circuits can be selected to couple the second port circuits for charging. According to different charging demand scenarios, different type or number of first electrical signal ports can be selected for charging, which can meet the needs of richer charging application scenarios, avoid overcurrent or overload pressure caused by single-channel charging, and avoid excessively high or rapid temperature rise of rechargeable batteries or electrical equipment.

Please refer to FIG. 1, FIG. 57 to FIG. 62. This embodiment provides a circuit for intelligent allocation of charging power and a method for intelligent allocation of charging power, so that the charging device 1 can realize intelligent distribution of charging power, and power allocation can be adjusted in time according to the conditions of the load (charged equipment). The charging device 1 can output multiple voltages at the same time, and can not only charge the specific vacuum cleaner 6 and battery pack 3, but also charge more common electronic devices, such as tablets and computers.

As shown in FIG. 57, this embodiment provides a circuit for intelligent allocation of charging power, which includes a primary winding 701, at least two secondary windings 702, a secondary winding control switch 703 corresponding to the secondary winding, an output port 704 corresponding to the secondary winding, a power complementary circuit 705 and a control module 706.

The secondary winding control switch 703 is used to control the on or off of the output port 704;
An input end of the power complementary circuit 705 is connected to an output end of the secondary winding 702, and an output end of the power complementary circuit 705 is connected to the output port 704 for controlling the output power complementation between the output ports 704.

The control module 706 is respectively connected to the output port 704, a control end of the power complementary circuit 705, and a control end of the secondary winding control switch 703, and is used to control a working state of the secondary winding control switch 703 and a working state of the power complementary circuit 705 according to current working state of the load (not shown in the figure) of each output port 704.

In some exemplary embodiments, the load can be a device to be charged, a battery to be charged, etc., which is not limited here.

In some exemplary embodiments, the secondary winding control switch may be provided between the secondary winding and the power complementary circuit as shown in FIG. 57, or may be provided at other locations in the circuit for intelligent allocation of charging power, which is not limited here. When the secondary winding control switch is turned on, its corresponding secondary winding starts to work, and the output port corresponding to the secondary winding outputs power. In this way, on or off of the corresponding output port can be achieved by controlling the on or off of the secondary winding control switch.

In some exemplary embodiments, the input end of the power complementary circuit is connected to the output end of the secondary winding, and the output end of the power complementary circuit is connected to the output port. In this way, the working state of the power complementary circuit can be controlled to realize the output complementary power between the output ports.

In some exemplary embodiments, the control module is connected to each output port, and can obtain the working state of the load connected to the output port, and then can control the working state of the secondary winding control switch and the working state of the power complementary circuit according to the current working state of the load of each output port.

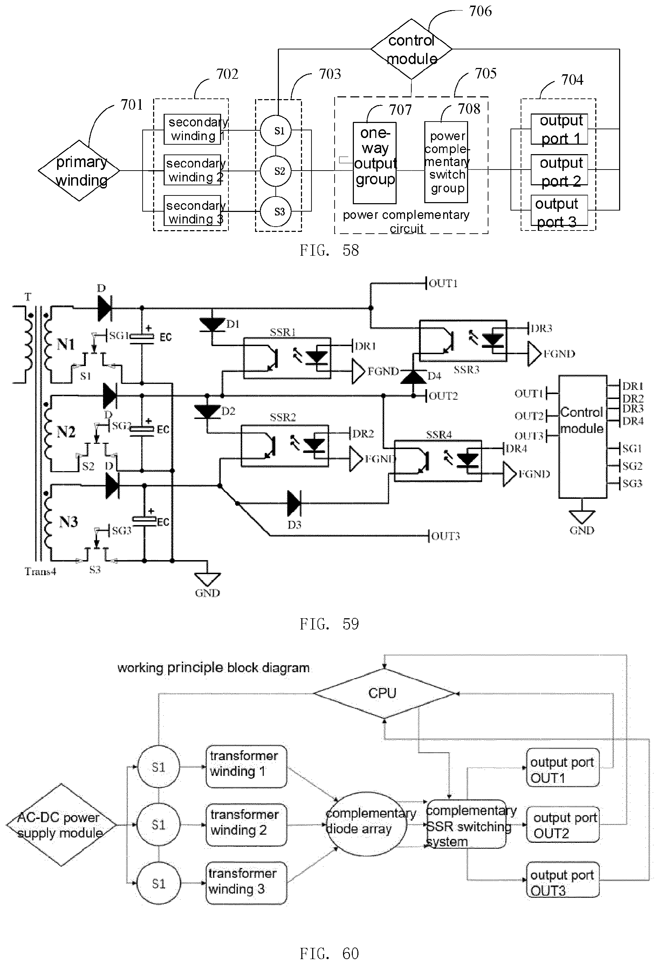

As shown in FIG. 58, in some embodiments, the control module determines at least one set of to-be-complementary output ports based on the current working state of the load of the output port. The set of to-be-complementary output ports includes a first output port and a second output port. The power complementary circuit 705 includes at least one power complementary switch group 708. The power complementary switch group 708 includes a first power complementary control switch and a second power complementary control switch. The input end of the first power complementary control switch is connected to the first output port. The output end of the first power complementary control switch is connected to the second output port, the input end of the second power complementary control switch is connected to the second output port, and the output end of the second power complementary control switch is connected to the first output port.

The control module controls the working state of the first power complementary control switch and the working state of the second power complementary control switch to achieve output power complementarity between the first output port and the second output port.

It should be noted that when output power complementarity between the first output port and the second output port is achieved, the working state of the first power complementary control switch and the working state of the second power complementary control switch are different.

In some embodiments, if the output power of the first output port is greater than the required power of the load corresponding to the first output port, and the output power of the second output port is less than the required power of the load corresponding to the second output port, the first power complementary control switch is used to control the output power of the first output port to be complementary to the second output port according to the control signal of the control module;
or,
if the output power of the first output port is less than the required power of the load corresponding to the first output port, and the output power of the second output port is greater than the required power of the load corresponding to the second output port, the second power complementary control switch is used to control the output power of the second output port to be complementary to the first output port according to the control signal of the control module.

In some embodiments, the power complementary switch group includes two optoelectronic modules.

Optional, optoelectronic modules include but are not limited to optocouplers, solid-state relays, etc.

In some embodiments, the current working state of the load includes the current of the load and the voltage of the load. The control module obtains each current and voltage to determine the output power, and determines at least one set of to-be-complementary output ports according to the output power and required power corresponding to each load.

The required power includes but is not limited to the rated power of the load.

In some exemplary embodiments, the set of to-be-complementary output ports can be determined in the following ways:
if there is only one load X corresponding to the output port A in the charging power intelligent distribution circuit, the required power of the load X is greater than the output power of the output port A, there is only one load Y corresponding to the output port B in the charging power intelligent distribution circuit, and the required power of the load Y is less than the output power of the output port B, then each difference between the required power of each load corresponding to each output port and the output power of corresponding output port is calculated, and then two output ports of which the differences are opposite but similar in absolute value are regarded as a set of to-be-complementary output ports;
if there are n loads X corresponding to the output port A in the charging power intelligent distribution circuit, the required power of the loads X is greater than the output power of the output port A, there are m loads Y corresponding to the output port B in the charging power intelligent distribution circuit, and the required power of the loads Y is less than the output power of the output port B, then each difference between the required power of the loads corresponding to each output port and the output power of corresponding output port is calculated, and then two output ports of which the differences are opposite but similar in absolute value are regarded as a set of to-be-complementary output ports.

For example, the required power (30W) of the load O corresponding to the output port Q is greater than the output power (25W) of the output port Q, and the required power (30W) of the load E corresponding to the output port P is less than the output power (45W) of the output port P, the required power (50W) of the load F corresponding to the output port R is less than the output power (54W) of the output port R, then the output port Q and the output port R are regarded as a set of to-be-complementary output ports.

**As** shown in FIG. 58, in some embodiments, the power complementary circuit also includes at least one-way output group 707. The one-way output group includes a first one-way output module and a second one-way output module. The first one-way output module is used to control the output power of the first output port to be complementary to the second output port, and the second one-way output module is used to control the output power of the second output port to be complementary to the first output port.

In some exemplary embodiments, the one-way output module includes but is not limited to a diode. The first one-way output module includes a first diode, the input end of the first diode is connected to the first output port, and the output end of the first diode is connected to the second output port through the first power complementary control switch, and the output power of the secondary winding corresponding to the first output port can be compensated to the second output port. The second one-way output module includes a second diode. The input end of the second diode is connected to the second output port, and the output end of the second diode is connected to the first output port through the second power complementary control switch. The output power of the secondary winding corresponding to the second output port can be compensated to the first output port.

It should be noted that the one-way output group can be arranged between the secondary winding control switch and the power complementary switch group as shown in FIG. 58, or it can be arranged between the power complementary switch group and the output port, which will not be limited here.

In some embodiments, a directional output module is also provided correspondingly between each secondary winding and the power complementary circuit.

In some exemplary embodiments, the directional output module includes but is not limited to a diode. By setting the directional output module, the current of the output port can be prevented from flowing back to the secondary winding.

It should be noted that each output port in the circuit for intelligent allocation of charging power in the embodiment can output the same or different voltages at the same time, and will not be affected by the feedback signal of the main power supply (primary winding). The output feedback signal source is independent primary feedback.

As shown in FIG. 59, the following takes a three-output port as an example to illustrate the circuit for intelligent allocation of charging power provided by this embodiment. The specific circuit for intelligent allocation of charging power includes: a primary winding T, a first secondary winding N1, a second secondary winding N2, a third secondary winding N3, a first secondary winding control switch S1 corresponding to the first secondary winding N1, a second secondary winding control switch S2 corresponding to the second secondary winding N2, a third secondary winding control switch S3 corresponding to the third secondary winding N3, an output port OUT1 corresponding to the first secondary winding N1, an output port OUT2 corresponding to the second secondary winding N2, an output port OUT3 corresponding to the three secondary windings N3, a power complementary circuit, and a control module. The power complementary circuit mainly composed of an one-way output module D1, a power complementary control switch SSR1, an one-way output module D2, a power complementary control switch SSR2, an one-way output module D3, a power complementary control switch SSR3, an one-way output module D4, and a power complementary control switch SSR4. Wherein, the control module is respectively connected to OUT1, OUT2, OUT3, a control terminal DR1 of SSR1, a control terminal DR2 of SSR2, a control terminal DR3 of SSR3, a control terminal DR4 of SSR4, a control terminal SG1 of S1, a control terminal SG2 of S2 and a control terminal SG3 of S3. An output terminal of D1 is connected to OUT2 through SSR1, an input terminal of D1 is connected to the first secondary winding N1. An output terminal of D2 is connected to OUT3 through SSR2, an input terminal of D2 is connected to the second secondary winding N2. An output terminal of D3 is connected to OUT2 through SSR4, an input terminal of D3 is connected to the third secondary winding N3. The output terminal of D4 is connected to OUT1 through SSR3, the input terminal of D4 is connected to the second secondary winding N2.

The specific circuit for intelligent allocation of charging power in the embodiment has three output ports, namely OUT1\OUT2\OUT3. The three output ports can output different voltages at the same time and will not be affected by the feedback signal of the main power supply. The output feedback signal source is independent primary feedback.

Optional, if the working state of the power complementary control switches in at least one power complementary switch group are different (one switch is on, one switch is off), and the secondary winding control switches corresponding to the two output ports (M and N) connected to the power complementary switch group are both in the on state, that is, the output port M and the output port N are in the normal conduction state, and there is a complementary output power of the output port M to the output port N or there is a complementary output power of the output port N to the output port M. The circuit for intelligent allocation of charging power works in the complementary mode. Since the power complementation is based on a certain voltage difference, the current can flow from the high voltage complementary winding to the low voltage complementary winding. When the voltages of the two groups are the same, it means that the loads are almost equal. Then the circuit can work in dual modes, one mode is the complementary mode and the other is the normal mode. The normal mode means that there is no power complementation between the two ports.

The specific working principle of the circuit for intelligent allocation of charging power is as follows:
assuming that when the OUT1 winding is to output 40W power of 20V2A, the specific circuit for intelligent allocation of charging power will close S1 to allow the secondary winding N1 to output normally, and the secondary windings N2 and N3 are cut off from the circuit via S2 and S3. The control method of working state of the output ports OUT2 and OUT3 is similar to that of OUT1, and will not be described again here.

Assuming that the OUT2 output port is a low-voltage and low-power output winding, then when the two windings OUT1 and OUT2 are to output power at the same time. Due to differences in circuit design, the output power of the two groups may be limited by the output balance rate, which may cause the output power of OUT1 and OUT2 is not required by the load. At this time, the specific circuit for intelligent allocation of charging power will transmit the actual output data to the control module based on the independent detection circuit of each output circuit. The control module will compare S1\S2 and DR1\DR3 of SSR1\SSR3 in the output signal drive circuit through data comparison, and respectively control the output power complementation between the two independent output ports OUT1 and OUT2.

The working principle of circuit complementation is as follows:
If OUT1 and OUT2 output at the same time, when the output power of OUT1 is not enough and the output power of OUT2 is too high, the circuit will turn on S2 according to the detection result. The drive signal RD3 of SSR3 will convert OUT1 and OUT2 from independent working mode to parallel mode. Since the output power of OUT1 is insufficient, when OUT2 and OUT1 are connected in parallel, the output power of the N2 winding sends the excess energy to the output port OUT1 of the N1 winding through the output port OUT2, realizing that excess energy of OUT2 is complementary to OUT1. When there is excess power in the OUT1 winding and not enough energy in OUT2, the circuit will turn off the drive signal DR3 of SSR3, cut out the OUT2 of the N2 winding from the circuit of OUT1, turn on the drive signal DR1 of SSR1, and connect the OUT1 of the N1 winding to the circuit of OUT2, then the remaining energy of OUT1 is complementary to OUT2 of the N2 winding through the D2 diode to achieve complementation.

In the same way, the energy complementary principle between OUT1\OUT2\OUT3 of the N1\N2\N3 winding can be deduced in the same way, and will not be repeated here.

Optional, if the output voltages of OUT1 and OUT2 are the same, the circuit for intelligent allocation of charging power will decide how to turn on SSR3 and SSR1 based on the voltage rise and change of OUT1 and OUT2, the purpose of which is to always keep the two outputs at basically the same level. Assuming that one of the batteries connected to the two output ports OUT1 and OUT2 has a large capacity and the other has a small capacity, then the voltage of the battery with the large capacity will rise slowly, and the voltage of the battery with the small capacity will rise quickly, so in this case, the circuit will naturally distribute the energy output by the port with the small battery capacity to the battery with the large capacity connected to the ports OUT1 and OUT2 through SSR3 or SSR1. That is to say, the circuit for intelligent allocation of charging power can work in dual modes, i.e. complementary mode and normal mode.

In some exemplary embodiments, the working state of the load can be detected using the existing detection circuit. By detecting the current and voltage, the control module obtains these current and voltage data, and then determines whether the output power of each output port is excessive or insufficient, in order to correspondingly control the on or off of the power complementary control switch in the corresponding power complementary circuit.

Refer to FIG. 60. FIG. 60 is a block diagram of the working principle of a circuit for intelligent allocation of charging power taking three output ports as an example. The control module takes a central processor as an example, the one-way output group takes a complementary diode array as an example, and the power complementary circuit takes the complementary SSR switching system as an example.

The circuit for intelligent allocation of charging power provided in one embodiment can be applied to vacuum cleaners, electric mops, sweeping robots, garden tools, electric tool chargers, chargers and other equipment.

The circuit for intelligent allocation of charging power provided by this embodiment helps to fixedly allocate the maximum output power to each output port, which can be applied to any multi-port charger or charging equipment, and can ensure that each output port of the charger does not output too large power and may not affect the maximum power of the total power supply, making the multi-function and multi-port charger more reliable and stable.

The circuit for intelligent allocation of charging power is based on feedback from the same charging power converter module (power supply module), which is fed back by the power supply module's autonomous wide-circuit feedback for self-control and total output power, with no interference or constraints from other feedback signal input.

The way to realize intelligent power allocation in the circuit for intelligent allocation of charging power in one embodiment of the disclosure is to control the output control circuits with the same output voltage, realize energy adjustment of multiple output ports through the control module, and drive different adjusted high-frequency switch tubes (the power complementary control switch in the power complementary circuit). And there is only one inductor in the circuit for intelligent allocation of charging power as an energy storage and copying device. The electromagnetic induction between different windings is inducted to realize the complementation of the output power of different loops to achieve regulation and control of intelligence allocation of power.

The circuit of the disclosure works in high-frequency mode and adopts an interleaved driving method. Only one control module is provided to obtain the working state of the output loops of different output ports, such as current and voltage, and determine the on and off of each power complementary switch in the power complementary switch group based on the working state of each output loop. Each independent output circuit has an on-off switch (secondary winding control switch). At the same time, each output circuit has complementary and adaptive diodes (one-way output group) with other output circuits.

In some exemplary embodiments, the power complementary circuit uses the unidirectional conductivity of the diode and the SSR solid-state switching system to form a working principle of output power complementary which is a mutually isolated and cooperative.

Through the control of power complementary circuits, originally independent output ports can realize that different power output ports can cooperate with each other in parallel when necessary, and the output ports and the circuits corresponding to the output ports will not affect each other.

The circuit for intelligent allocation of charging power in one embodiment truly realizes intelligent power allocation between multiple windings and a single transformer, which is adjustable in real time.

The circuit for intelligent allocation of charging power provided in one embodiment can solve the problem of output imbalance of multiple sets of output power supply products. It realizes the function of multiple outputs and independent adjustment by adding a few components, and does not need to design a unique BUCK circuit. It can be used in situations where the output power is large, and it is also suitable for situations where the output power is small, which has a wide range of application scenarios and improves circuit conversion efficiency and output power utilization.

In some exemplary embodiments, when designing a multi-output multi-winding transformer, the number of turns of multiple windings of the transformer can be set to a same number of turns according to the design input parameters. There is no need to design separate transformer turns for each different output voltage channel.

In some exemplary embodiments, when the output power between the output ports is complementary, the two secondary windings are connected in parallel, which can effectively reduce the heating of the transformer coil and reduce the iron loss of the transformer.

The disclosure also provides a charger, including the circuit for intelligent allocation of charging power as described in any of the above embodiments.

The technical effect that the charger can achieve is similar to the circuit for intelligent allocation of charging power in the above embodiment, and will not be described again here.

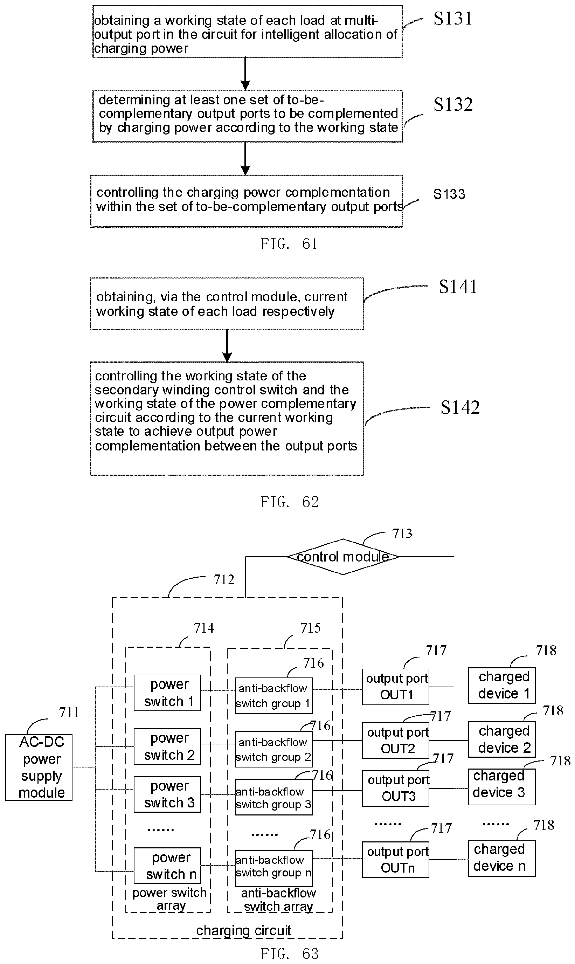

Referring to FIG. 61, the disclosure also provides a method of intelligent allocation of charging power, which includes:
S131: obtaining the working state of each load at the multi-output port in the circuit for intelligent allocation of charging power;
S132: determining at least one set of to-be-complementary output ports to be complemented by charging power according to the working state; and
S133: controlling the charging power complementation within the set of to-be-complementary output ports.

In some exemplary embodiments, each load is connected to the same circuit for intelligent allocation of charging power, and the circuit is powered by only one power module.

The working state of each load can be obtained through detection through existing relevant detection circuits. The working state includes but is not limited to current, voltage, etc.

In some exemplary embodiments, controlling the charging power complementation within the set of to-be-complementary output ports includes:
determining a receiving charging power output port and a compensation charging power output port from the set of to-be-complementary output ports; and
controlling the receiving charging power output port to be connected to the compensation charging power output port.

In some exemplary embodiments, the current working state of the load includes the current and voltage of the load. Each current and voltage is obtained to determine the output power, and at least one set of to-be-complementary output ports is determined according to the output power and required power corresponding to each load. The required power includes but is not limited to rated power, etc.

In some exemplary embodiments, the working state includes the required power of the load and the output power of the output port. Determining at least one set of to-be-complementary output ports to be complemented by charging power according to the working state includes:
obtaining an output power of the output port connected to each load and a required power of the load;
determining an output port to receive charging power and an output port to compensate charging power according to the output power and required power;
determining power differences of each output port to receive charging power and each output port to compensate charging power; and
pairing each output port to receive charging power and output port to compensate charging power according to the power differences, and determining at least one set of to-be-complementary output ports.

The output port to receive charging power is the output port corresponding to the load of which output power is less than the required power. The output port to compensate charging power is the output port corresponding to the load of which output power is greater than the required power. The power difference is the output power minus the required power.

In some exemplary embodiments, pairing each output port to receive charging power and output port to compensate charging power according to the power differences may be achieved by selecting two output ports with power differences of opposite signs and similar absolute values. Or the pairing may be achieved by selecting two output ports with power differences that meet a preset threshold. The preset threshold can be set by those skilled in the art as needed, such as 0, 0.6, etc.

The receiving charging power output port and the compensation charging power output port are also the output port to receive charging power and the output port to compensate charging power in the set of to-be-complementary output ports.

In some embodiments, the working state of the load includes the output voltage, and the method further includes:
reacquiring the output voltage of the load; and
if the output voltages of the two loads corresponding to the set of to-be-complementary output ports meet preset conditions, suspending reception of complementary charging power between the receiving charging power output port and the compensation charging power output port.

The method of intelligent allocation of charging power in one embodiment can provide multiple output ports for the same power supply module. A wide voltage output may be achieved according to the charging state of the charged device, such as the current and voltage information of the charged device, without using an independent DCDC voltage conversion circuit. A directional charging energy control and directional output may be realized according to the charging state of the charged device. An independent regulation of multiple outputs is achieved by cooperating different charged devices with bridge circuits of the preset detection circuit and the output ports, without the need for additional BUCK circuit, which has low cost, high circuit conversion efficiency, high output power utilization, and wide application scenarios.

In some exemplary embodiments, this method of charging energy distribution is applied to the circuit for intelligent allocation of charging power in any one of the above embodiments. The technical effects achieved by this method of charging energy distribution are similar to those of the circuit for intelligent allocation of charging power in the above embodiments, and will not be used here.

Referring to FIG. 62, the embodiment provides a control method of a circuit for charging energy distribution, which is applied to the circuit for intelligent allocation of charging power in any embodiments. The control method includes:
S141: obtaining, via the control module, current working state of each load respectively; and
S142: controlling the working state of the secondary winding control switch and the working state of the power complementary circuit according to the current working state to achieve output power complementation between the output ports.

In some exemplary embodiments, controlling the working state of the secondary winding control switch and the working state of the power complementary circuit according to the current working state to achieve output power complementation between the output ports includes:
determining, via the control module, at least one set of to-be-complementary output ports according to the current working state, and the set of to-be-complementary output ports includes a first output port and a second output port;
the power complementary circuit including at least one power complementary switch group, and the power complementary switch group including a first power complementary control switch and a second power complementary control switch; and
controlling, via the control module, working state of the first power complementary control switch and working state of the second power complementary control switch to achieve output power complementarity between the first output port and the second output port.

In some exemplary embodiments, the control module controls the first power complementary control switch between the set of to-be-complementary output ports to be turned on and the second power complementary control switch between the set of to-be-complementary output ports to be turned off, so as to realize the output power compensation of the first output port to the second output port. Or the control module controls the first power complementary control switch between the set of to-be-complementary output ports to be turned off and the second power complementary control switch between the set of to-be-complementary output ports to be turned on, so as to realize the output power compensation of the second output port to the first output port.

In some exemplary embodiments, the current working state includes the output voltage of the output port corresponding to the load. The control method also includes:

Reacquiring, via the control module, the output voltage; and
if the output voltages of the two loads corresponding to the set of to-be-complementary output ports meet preset conditions, the control module issuing a control instruction to turn off the first power complementary control switch and the second power complementary control switch.

Through the control method of a circuit for intelligent allocation of charging power provided in the embodiment, the function of independent adjustment of multiple outputs is realized without the need for additional BUCK circuits, which has low cost, high circuit conversion efficiency, high output power utilization, and wide application scenarios.

The technical effects achieved by this method of intelligent allocation of charging power are similar to those of the circuit for intelligent allocation of charging power in the above embodiment, and will not be described again here.

Please refer to FIGS. 1 to 63. This embodiment provides a charging device 1 for method and circuit for intelligent allocation of charging power, which realizes intelligent allocation of charging power and adjusts power allocation in a timely manner according to the conditions of the load (charged equipment). The charging device 1 can output multiple voltages at the same time, which can not only charge the specific vacuum cleaner 6 and battery pack 3, but also charge more common electronic devices, such as tablets and computers.

**As** shown in FIG. 63, in another embodiment of the disclosure, the circuit for charging energy distribution includes a charging circuit 712, a plurality of output ports 717 and a control module 713. The charging circuit 712 includes a power switch array 714 and an anti-backflow switch array 715;

The power switch array 714 includes at least two power switches. The input end of the power switch is connected to the alternating current - direct current power supply module (AC-DC power supply module) 711 for controlling the working state of the output port 717;

The anti-backflow switch array 715 includes at least two anti-backflow switch groups 716. The input end of the anti-backflow switch group 716 is connected to the output end of the power switch. The output end of the anti-backflow switch group 716 is connected to the output port 717. The control end of the anti-backflow switch group 716 is connected to the control module 713 to prevent reverse current.

The control module 713 is used to obtain the charging state of the charged device 718 of each output port 717, and control the on or off of each power switch and each anti-backflow switch group 716 according to the charging state to achieve distribution of charging energy.

In some embodiments, if there is a target charged device, the control module controls the power switch and the anti-backflow switch group corresponding to the target charged device to be turned on, and the control module controls the remaining power switches and the remaining anti-backflow switch groups to be turned off, where, the target charged device is the charged device of which charging state reaches the preset charging state.

In some embodiments, if the charging state of the target charged device deviates from the preset charging state, the control module controls each power switch and each anti-backflow switch group to be turned on.

In some exemplary embodiments, the control module controls each power switch and each anti-backflow switch group to be turned on, that is, all power switches and all anti-backflow switch groups are turned on. Then the circuit for charging energy distribution performs normal charging mode. When working in normal charging mode, the circuit provides a maximum output charging power (energy). The charged device connected to the circuit enters the CC or CV mode for charging according to its own voltage state. The current allocated to the output port is determined by the voltage of the charged device, the one with high voltage is allocated a small charging current, and the one with low voltage is allocated a large current, which is actually an adaptive charging mode.

If among the charging states of each charged device obtained by the control module, the charging state of at least one charged device reaches the preset charging state, the control module controls the charging circuit corresponding to the charged device of which the charging state reaches the preset charging state to be turned on and controls the charging circuits corresponding to the remaining charged devices of which the charging states have not reached the preset charging state to be turned off, in order to charge the charged device of which the charging state has reached the preset charging state with concentrated power, which can provide better charging services to key charged device and improve customer experience. For example, the charging state includes the remaining power, and the preset charging state includes the remaining power being less than 10%. For a charged device with less than 10% remaining power, charging is often urgently needed to reach a safer remaining power state. Therefore, charging energy can be allocated to give priority to the charging needs of such charged device and the charging of remaining charged devices may be suspended. Once the remaining power of the charged device reaches more than 10%, the "charging priority treatment" for the charged device will be cancelled, the charged device and remaining charged devices in the circuit for charging energy distribution are charged equally, that is, charging of all charged devices is started.

In some exemplary embodiments, the charging state of the charged device can be monitored through existing relevant technical means, which is not limited here.

In some exemplary embodiments, the charging state includes but is not limited to at least one of remaining power, charging priority, remaining power change speed, remaining power available time, etc. Where the remaining power is the current battery power of the charged device, and the remaining power can be expressed in terms of current battery level, percentage of current remaining power, etc. The charging priority can be a pre-set priority for a specific charged device. The remaining power change speed can be a regular or real-time monitoring of the remaining power of the charged device, then the changing speed of the remaining power of the charged device can be determined; for example, if the remaining power is monitored once every 1 minute, if the remaining power increases by 0.3% obtained by comparing the two adjacent monitoring results, it can be considered that the remaining power changing speed is 0.3%/ min; if, the remaining power decreases by 0.3% obtained by comparing two adjacent monitoring results, the remaining power change speed can be considered to be -0.3%/min. The remaining power available time is an estimated value, which can be determined based on the history using data and/or current output power, etc. of the charged device.

Optional, the preset charging state includes but is not limited to at least one of the following:
the remaining power is less than the preset minimum remaining power;
the remaining power change speed is less than 0;
the remaining power change speed is less than a preset change speed threshold, and the preset change speed threshold is greater than 0;
the priority of the charged device is higher than a preset priority threshold; and
the remaining power available time is less than a preset minimum available time, etc.

Sometimes the charged device is used while charging. If the charging power currently allocated to the charged device is small and insufficient to support its use needs, then the remaining power change speed may also be less than 0. At this time, when this type of " demand exceeds supply " and the support of greater charging power is urgently needed to meet the normal use of the charged device, the control module can be used to control the power switch and anti-backflow switch group corresponding to the charged device to be turned on and control the power switches and anti-backflow switch groups of all remaining charged devices to be turned off. When the remaining power change speed of the charged device is greater than 0 and greater than the preset change speed threshold, it means that the operation of the charged device has returned to "normal". Then the power switch and the anti-backflow switch group corresponding to each charged device can be turned on through the control module, which starts the normal charging mode.

In some exemplary embodiments, the anti-backflow switch group includes at least two anti-backflow switches.

In some exemplary embodiments, anti-backflow switches include field effect tubes, such as MOST power switch tubes, etc.

In some exemplary embodiments, the anti-backflow switch group includes one first power switch tube and one second power switch tube connected in series, where a first end of the first power switch tube is connected to the output end of the power switch, and a second end of the first power switch tube is connected to a first end of the second power switch tube, a third end of the first power switch tube is connected to the control module, a second end of the second power switch tube is connected to the output port, and the second end of the second power switch tube is connected to the control module.

In some exemplary embodiments, the anti-backflow switch group includes at least two MOST power switch tubes, or one or more diodes.

It should be noted that the charged device includes, but is not limited to, at least one of rechargeable batteries, rechargeable devices, etc.

In some exemplary embodiments, the anti-backflow switch group includes a first anti-backflow end connected to the output end of the power switch and a second anti-backflow end connected to the output port. When the voltage of the first anti-backflow end is higher than the voltage of the second anti-backflow end and the control module controls the anti-backflow switch group to be turned on, the anti-backflow switch group is turned on. Otherwise, when the voltage of the first anti-backflow end is not higher than the voltage of the second anti-backflow end or the control module controls the anti-backflow switch group to be turned off, then the anti-backflow switch group is turned off.

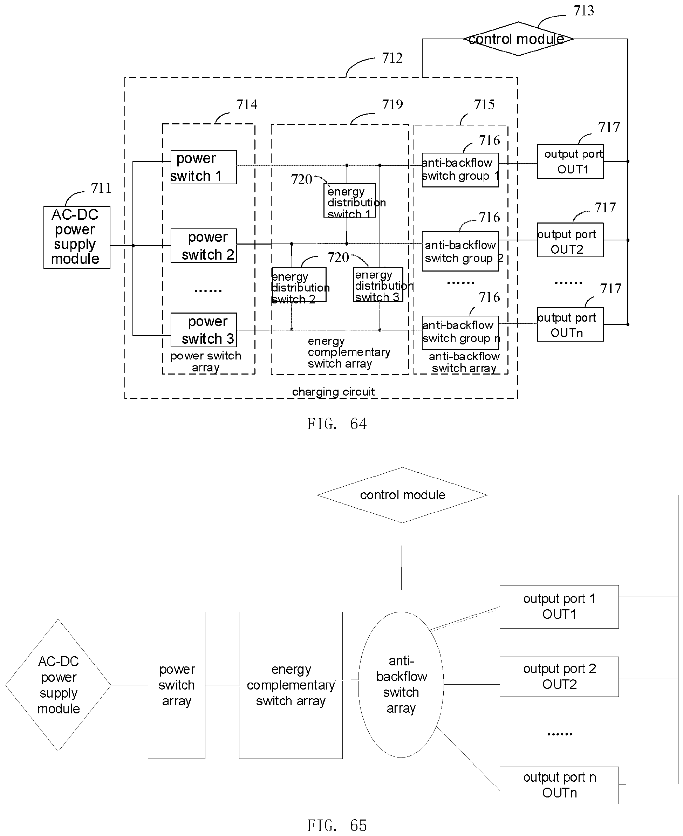

Referring to FIG. 64, in other embodiments, the circuit for charging energy distribution also includes: an energy complementary switch array 719.

The energy complementary switch array 719 includes at least one energy distribution switch 720. A first end of the energy distribution switch 720 is connected to the output end of one power switch, and the second end of the energy distribution switch 720 is connected to the output end of another power switch, in order to control the energy distribution between the output ports 717. The control module 713 is also used to control the on or off of the energy distribution switch 720.

In some exemplary embodiments, continue to refer to FIG. 64. One energy distribution switch is connected to the output ends of two power switches. When there are multiple power switches, each energy distribution switch in the energy complementary switch array is connected to the output terminals of two power switches respectively, the output ends of any two power switches are connected to one energy distribution switch. If there are N power switches, that is, N ports, the number of energy distribution switches is at least. The output terminals of any two power switches can also correspond to one or more energy distribution switches. The energy distribution switches can be in one-way conduction or multi-way conduction.

In some embodiments, the charging state includes battery voltage. If the voltage difference between the batteries of the first charged device and the second charged device exceeds a preset voltage difference threshold, the control module controls the energy distribution switch connecting the first charged device and the second charged device to be turned on, so as to realize that the first charged device charges the second charged device, and the voltage of the battery of the first charged device is higher than the voltage of the battery of the second charged device.

It should be noted that the first charged device and the second charged device may be any two charged devices among the charged devices connected to the circuit for charging energy distribution. The above-mentioned "first" and "second" do not specifically refer to two charged devices, but for clarity of reference, the charged devices having voltage difference between the two batteries exceeds the preset voltage difference threshold are named the first charged device and the second charged device.

If the voltage difference between the batteries of the charged devices A and B exceeds the preset voltage difference threshold, in order to achieve a certain charging balance for each charged device in the circuit, the energy distribution switch between the output ends of the power switches of the two charged devices A and B is controlled to be turned on. Due to the existence of the voltage difference, the charged device with a higher battery voltage can complementarily charge the charged device with a lower battery voltage, thereby enabling all charged devices connected to the circuit to work stably. The preset voltage difference threshold may be a preset maximum allowable voltage difference between the charged circuits in the circuit for charging energy distribution, such as 0.5V.

It should be noted that if the circuit for charging energy distribution includes an energy complementary switch array, the anti-backflow switch in the circuit for charging energy distribution includes a MOST power switch tube.

Please refer to FIG. 65, which is a block diagram of the working principle of the circuit for charging energy distribution provided by the embodiment of the disclosure. As shown in FIG. 65, the circuit for charging energy distribution has three working states: a normal charging mode, a directional charging energy distribution mode and an energy complementary mode. When the control module recognizes that the charging state of the charged device M connected to a certain output port reaches the preset charging state, such as its remaining power is less than 50%, the circuit for charging energy distribution is adjusted to enter the directional charging energy distribution mode, and then the power switch and anti-backflow switch group corresponding to the charging device M are turned on and remaining power switches and anti-backflow switch groups are turned off, so as to charge the charged device M with the maximum charging power. After the charged device M is charged for a period of time, if the charged device M leaves the preset charging state, such as its remaining power is higher than 50%, the circuit for charging energy distribution is adjusted to enter the normal charging mode, and the power switch and anti-backflow switch group are corresponding to each charged device are turned off. At this time, the circuit for charging energy distribution provides the maximum output charging power (energy), and each charged device connected to the circuit chooses to enter CC or CV charging mode according to its own voltage status. The current allocated to the output port is determined by the voltage of the charged device. The charging current allocated to the device with high voltage is small, and the charging current allocated to the device with low voltage is large. It is actually an adaptive charging mode. When among the charged devices connected to the circuit for charging energy distribution, a battery voltage difference between two charged devices Q and P exceeds the preset voltage difference threshold, the power switches corresponding to the charged device Q and the charged device P are respectively power switch S and power switch F. The output ends of power switch S and power switch F are connected to the energy distribution switch Z. Then the control module controls the energy distribution switch Z to be turned on, and the circuit for charging energy distribution enters the energy complementary mode, which can realize that the charged device with a higher battery voltage can complementarily charge on the charged device with a lower battery voltage, so that all the charged devices connected to the system can work stably. It should be noted that when the circuit for charging energy distribution operates in the energy complementary mode, the voltage differences between the charged devices are not allowed to be too large, for example, the maximum voltage difference does not exceed 0.5V.

The circuit for charging energy distribution provided in the embodiment realizes the control of different output voltages by using the same power module corresponding to multiple output ports through the cooperation of the power switch array, the anti-backflow switch array and the control module, which has low cost, small power delivery, high power conversion efficiency and utilization. In some exemplary embodiments, an anti-backflow switch group is provided to control mutual charging and current backflow caused by voltage differences between multiple charged devices.

In some exemplary embodiments, the control module detects the charging state of the charged device connected to the output port to determine whether there is a charged device (target charged device) that requires priority charging. If there is a target charged device, the circuit enters directional energy distribution mode, the control module controls the power switch and anti-backflow switch group corresponding to the target charged device to be turned on and controls the remaining power switches and anti-backflow switch groups to be turned off, so as to provide the maximum output charging power for the target charged device, realizing the function of automatically detecting and directional charging of the target charged device. The charging efficiency is improved. In an emergency, the operation of the target charged device can be rapidly recovered or the battery capacity of the target charged device can be rapidly recovered.

The circuit for charging energy distribution provided in the embodiment can supply power to different output ports through one power module, achieve wide voltage output based on current information without using an independent DCDC voltage conversion circuit, realize directional charging energy control and output according to the load condition (charging state of the charged device), and cooperate with different loads to realize directional energy control through a specific bridge circuit system between the detection circuit and the output port.

The circuit for charging energy distribution provided in the embodiment uses only one total independent power supplier. The circuit for charging energy distribution has two working modes, one is a constant current working mode and the other is a constant voltage working mode. When the circuit for charging energy distribution operates in the energy complementary mode or the directional charging energy distribution mode, it will enter the constant voltage working mode. The output voltage is adjusted to be the same as or slightly higher than the voltage of the load according to voltage condition of the load (target charged device) connected through the directional port (the output port corresponding to the target charged device). The load is electrically connected to the circuit for charging energy distribution, and the circuit begins to enter the directional charging energy distribution mode to charge the load. The circuit for charging energy distribution determines whether the charged devices corresponding to other output ports need to be charged at the same time based on the charging state of the currently connected load. If so, a certain charging current is allocated to the charged devices. For example, when the charging state of the charged device D reaches the preset charging state, the circuit for charging energy distribution enters the directional charging energy distribution mode, suspends the charging of other charged devices, and starts charging the charged device D with the maximum output power. In the subsequent process, the control module collects that the charging state of the charged device F has also reached the preset charging state, and then turns on the charging circuit of the charged device F, and charges the charged device D and the charged device F at the same time.

In some exemplary embodiments, the circuit for charging energy distribution provided in the embodiment can be applied to at least one of vacuum cleaners, garden tools, electric tool chargers, chargers, etc.

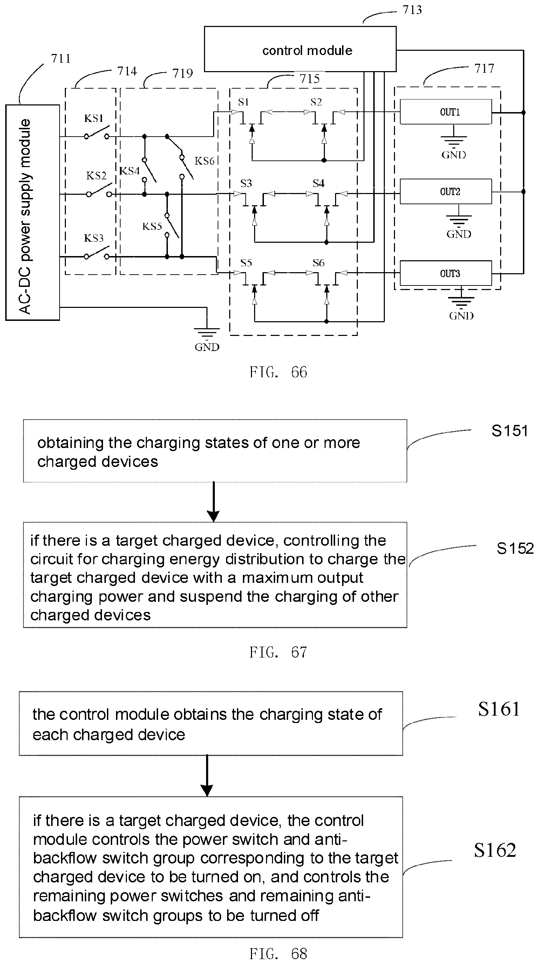

Please refer to FIG. 66. The circuit for charging energy distribution provided by this embodiment is illustrated below through a specific embodiment. FIG. 66 is a specific circuit for charging energy distribution. The circuit includes an AC-DC power supply module 5 as a power module, a power switch array 714 having three power switches KS1, KS2, and KS3, an energy complementary switch array 719 having three energy distribution switches KS4, KS5, and KS6, a control module 713 and an output port 717. The energy complementary switch array includes a first anti-backflow switch group, a second anti-backflow switch group and a third anti-backflow switch group. The first anti-backflow switch group is composed of S1 and S2, the second anti-backflow switch group is composed of S3 and S4, and the third anti-backflow switch group is composed of S5 and S6. The output port includes OUT1, OUT2 and OUT3.

Continuing to refer to FIG. 66, OUT1, OUT2, and OUT3 are respectively the three output ports of the circuit for charging energy distribution, and the output ports are connected to the corresponding devices to be charged.

Power switch KS1, power switch KS2, and power switch KS3 are used to control the on and off of the three output ports and can be regarded as first-level switches. The anti-backflow switch S1, anti-backflow switch S2, anti-backflow switch S3, anti-backflow switch S4, anti-backflow switch S5, and anti-backflow switch S6 can be regarded as the second-level switched and adjustment system in the circuit for charging energy distribution, which is used to prevent the risk of receiving reverse current from the charging device in the directional energy distribution working mode.

When the working mode of the circuit for charging energy distribution is the normal charging mode, the power switch KS1, the anti-backflow switch S1 and the anti-backflow switch S2; the power switch KS2, the anti-backflow switch S3 and the anti-backflow switch S4; and the power switch KS3, the anti-backflow switch S5 and the anti-backflow switches S6 form three sets of independent switch arrays to connect each charged device to the circuit for charging energy distribution, respectively.

When the circuit for charging energy distribution works in the directional charging energy distribution mode, for example, the control module automatically recognizes OUT3 as the selected directional charging energy output port. At this time, the control module will turn off the anti-backflow switch S1, anti-backflow switch S2, and anti-backflow switch. S3, and anti-backflow switch S4, and turn off the power switch KS3, anti-backflow switch S5, and anti-backflow switch S6. The circuit for charging energy distribution begins to charge the charged device on OUT3 in the circuit with the maximum charging power. After charging for a period of time, the circuit then decides whether to connect the charged device connected to OUT1 and OUT2 to the circuit for charging energy distribution for charging according to the actual situation.

In some exemplary embodiments, the directional energy distribution function of the circuit for charging energy distribution does not require any external operation or button selection. The circuit for charging energy distribution automatically switches according to the charging stages of the connected charged devices. When the power of any charged device in the circuit for charging energy distribution is less than 50%, the circuit for charging energy distribution will switch the charged device to the directional charging mode for charging, and automatically exit the directional charging ang enter normal charging mode when the capacity of the charged device is charged to more than 50%.

When the battery capacity status of all charged devices in the circuit for charging energy distribution is above 50%, the circuit for charging energy distribution will not enter the directional energy distribution mode for charging. At this time, the circuit for charging energy distribution is fully working in the normal charging mode. When working in the normal mode, the circuit for charging energy distribution provides the maximum output charging power (energy). The charged device connected to the circuit enters the CC or CV mode for charging according to its own voltage state. The current allocated to the output port is determined by the voltage of the charged device, the one with high voltage is allocated a small charging current, and the one with low voltage is allocated a large current, which is actually an adaptive charging mode.

The energy distribution switch KS4, energy distribution switch KS5, and energy distribution switch KS6 in the circuit for charging energy distribution are second-level directional energy distribution switches. Under the control of the energy distribution switches, the charged device with a higher battery voltage can be used to complementarily supply power to the charged device with a lower battery voltage, so that all the charged device connected to the circuit for charging energy distribution can work very stably. When the circuit for charging energy distribution works in the energy complementary mode, the voltage difference between the charged devices is not allowed to be too large, that is, it cannot exceed the preset voltage difference threshold. When the voltage difference between two charged devices exceeds the preset voltage difference threshold, the circuit for charging energy distribution enters the energy complementary mode. Optional, the preset voltage difference threshold is 0.5V.

The disclosure also provides a charger, including the circuit for charging energy distribution as described in any of the above embodiments.

The technical effect that the charger can achieve is similar to the circuit for charging energy distribution in the above embodiments, and will not be described again here.

Referring to FIG. 67, and a circuit for charging energy distribution shown in FIGS. 64 to 66, the embodiment provides a method of charging energy distribution, and the method includes: S151 and S152.

S151: obtaining the charging states of one or more charged devices.

In some exemplary embodiments, each charged device is connected to the same circuit for charging energy distribution, and the circuit is powered by one power module.

S152: If there is a target charged device, controlling the circuit for charging energy distribution to charge the target charged device with the maximum output charging power and suspend the charging of other charged devices.

It should be noted that the target charged device is a charged device of which the charging state reaches the preset charging state.

In some exemplary embodiments, the charging circuit of other charged devices can be turned off and only the charging circuit of the target charged device can be turned on, so that the circuit for charging energy distribution can charge the target charged device with the maximum output charging power.

In some exemplary embodiments, the above circuit switching can be realized through the controller.

In some exemplary embodiments, the charging state of each charged device can be monitored in real time or at certain intervals. The specific charging state acquisition can be implemented using existing relevant technical means, which is not limited here.

In some exemplary embodiments, if the charging state of the target charged device deviates from the preset charging state, each of the charged devices is recharged again.

By controlling the conduction of the charging circuit corresponding to each charged device, all the charged devices can be charged.

In some exemplary embodiments, the charging state includes battery voltage, and the method also includes:
if the difference in battery voltage between the first charged device and the second charged device exceeds the preset voltage difference threshold, the first charged device is controlled to charge the second charged device, and the battery voltage of the first charged device is higher than the battery voltage of the second charged device.

The method of charging energy distribution provided by the embodiment can provide multiple output ports of the same power supply module, achieve wide voltage output according to the charging state of the charged device, such as the current information of the charged device without using an independent DCDC voltage conversion circuit., realize directional charging energy control and output according to the charging state of the charged device, cooperate with different charged devices to achieve directional energy control through the preset bridge circuit between the detection circuit and the output port, which has low cost, small power supply, high the power conversion efficiency and utilization rate.

In some exemplary embodiments, this method of charging energy distribution is applied to the circuit for charging energy distribution in any one of the embodiments. The technical effects achieved by this method of charging energy distribution are similar to those of the circuit for charging energy distribution in the above embodiments, and will not be repeated here.

Please refer to FIG. 68. This embodiment provides a control method of circuit for charging energy distribution, which is applied to the circuit for charging energy distribution of any one of the above embodiments. The method includes: S161 and S162.

S161: The control module obtains the charging state of each charged device.

S162: If there is a target charged device, the control module controls the power switch and anti-backflow switch group corresponding to the target charged device to be turned on, and controls remaining power switches and remaining anti-backflow switch groups to be turned off.

It should be noted that the target charged device is a charged device whose charging state reaches the preset charging state.

In some exemplary embodiments, if the charging state of the target charged device deviates from the preset charging state, the control module controls each power switch and each anti-backflow switch group to be turned on.

This embodiment provides a control method of circuit for charging energy distribution, which can be applied to any circuit for charging energy distribution including an energy complementary switch array in the embodiments. The method includes:
**the** control module obtaining the charging state of each charged device; and
if the voltage difference between the batteries of the first charged device and the second charged device exceeds a preset voltage difference threshold, the control module controls the energy distribution switch connecting the first charged device and the second charged device to be turned on, so as to realize that the first charged device charges the second charged device, and the voltage of the battery of the first charged device is higher than the voltage of the battery of the second charged device.

Through the control method of circuit for charging energy distribution provided in the embodiment, it is possible to use the same power module corresponding to multiple output ports to perform different voltage output control, with low cost, small power supply, and high power conversion efficiency and utilization rate. In some exemplary embodiments, an anti-backflow switch group is provided to control mutual charging and current backflow caused by voltage differences between multiple charged devices.

The technical effects achieved by this method of charging energy distribution are similar to those of the circuit for charging energy distribution in the above embodiment, and will not be described again here.

In the description of this specification, reference to the description of the terms "this embodiment", "example", "specific example", etc. means that the specific features, structures, materials or characteristics described in connection with the embodiment or example are included in at least one embodiment or example of the disclosure. In this specification, schematic representations of the above terms do not necessarily refer to the same embodiment or example. Furthermore, the specific features, structures, materials or characteristics described may be combined in any suitable manner in any one or more embodiments or examples.

The above disclosed embodiments of the disclosure are only used to help explain the disclosure. The embodiments do not exhaustively describe all the details, nor do they limit the disclosure to the specific implementations described. Obviously, many modifications and variations are possible in light of the contents of this specification. This specification selects and specifically describes these embodiments to better explain the principles and practical disclosures of the disclosure, so that those skilled in the art can better understand and utilize the disclosure. The disclosure is limited only by the claims and their full scope and equivalents.

## Claims

1. A charging device, comprising:
a housing, defining a receiving cavity;
a circuit board, arranged in the receiving cavity;
an input part, provided on the housing and configured for connection to an external power supply; and
a plurality of output parts, provided on the housing, the input part and the output part being electrically connected via the circuit board;
wherein each of the output parts comprises at least one terminal, and the terminal is arranged in the receiving cavity and passes through the housing to a surface of the housing.

2. The charging device according to claim 1, wherein the output part comprises a first output part, a second output part and a third output part, the first output part, the second output part and the third output part are of different types.

3. The charging device according to claim 1, further comprising a receiving groove provided on the housing to accommodate an electronic device.

4. The charging device according to claim 1, further comprising an output protection device, wherein the output protection device is arranged on one of the terminals and allows the output protection device to cover and expose the terminal.

5. The charging device according to claim 4, wherein the output protection device comprises:
a fixing part, which is arranged in the housing of the charging device and is fixedly connected to the housing; and
a sliding part, arranged between the fixing part and the housing, the sliding part is capable of sliding between a first position and a second position;
when the sliding part is in the first position, the sliding part is configured to cover the output part of the charging device, and when the sliding part is in the second position, the output part of the charging device is at least partially exposed to the sliding part.

6. The charging device according to claim 5, wherein the sliding part is provided with a sliding protrusion, the sliding protrusion is located on the sliding part proximate to an opening in the housing, the sliding protrusion passes through the opening and allows the sliding protrusion to slide in the opening.

7. The charging device according to claim 1, wherein a side of the housing is provided with a locking structure, and the locking structure comprises:
a first locking unit, arranged at a bottom of the charging device; and
a second locking unit, arranged on a top of a fixed base, and the second locking unit being detachably connected to the first locking unit.

8. The charging device according to claim 7, wherein the first locking unit comprises:
a plurality of sliding ribs, arranged on one side of the first locking unit, and the plurality of sliding ribs being parallel to each other; and
a locking groove, provided on one side of the plurality of sliding ribs, and the locking groove being arranged on a side surface of the first locking unit where the first locking unit is connected to the bottom of the charging device.

9. The charging device according to claim 8, wherein the second locking unit comprises:
a plurality of matching sliding ribs, arranged parallel to each other and capable of being interspersed and fitted with the plurality of sliding ribs; and
a locking member, arranged in the second locking unit and capable of be inserted into or disengaged from the locking groove;
wherein, when the locking member is inserted into the locking groove, the first locking unit and the second locking unit are locked;
when the locking member is disengaged from the locking groove, the first locking unit and the second locking unit are unlocked.

10. The charging device according to claim 1, wherein a wall-mounted locking device is further provided on one side of the housing, and the wall-mounted locking device comprises:
a backboard body, arranged on a vertical wall; and
a backboard mating part, provided on the housing and detachably connected to the backboard body.

11. The charging device according to claim 10, wherein the backboard body comprises:
a slideway provided on the backboard body, and
a clamping member arranged on the backboard body.

12. The charging device according to claim 11, wherein the backboard mating part comprises:
a mating slideway, provided on the backboard mating part and cooperates with the slideway to allow the slideway to slide within the matching slideway; and
a clamping member mating structure, provided on the backboard mating part and fitted with the clamping member.

13. The charging device according to claim 12, wherein the matching slideway comprises a first matching slideway and a second matching slideway, the first matching slideway and the second matching slideway are symmetrically arranged on the backboard mating part, the matching slideway is fitted with the slideway, and the slideway is capable of sliding in the matching slideway.

14. A charging assembly, comprising:
a charging device, comprising:
a housing, defining a receiving cavity,
a circuit board, arranged in the receiving cavity,
an input part, provided on the housing and configured for connection to an external power supply, and
a plurality of output parts, provided on the housing, the input part and the output part being electrically connected through the circuit board,
wherein each of the output parts comprises at least one terminal, and the terminal is arranged in the receiving cavity and passes through the housing to a surface of the housing; and
an electronic device, electrically connected to the terminal of the charging device.

15. The charging assembly according to claim 14, wherein the electronic device is a battery pack, the battery pack is fixed on the housing, and the battery pack is provided with a plurality of ports, the ports are coupled with the terminals.

16. The charging assembly according to claim 14, wherein the electronic device is a vacuum cleaner, the vacuum cleaner is fixed on the housing, the vacuum cleaner is provided with a charging port, and the charging port is coupled with one of the term inals.

17. A charging man-machine interaction system, comprising:
a charging module, and the charging module comprising:
a housing, defining a receiving cavity,
a circuit board, arranged in the receiving cavity,
an input part, provided on the housing and configured for connection to an external power supply, and
a plurality of output parts, provided on the housing, the input part and the output part being electrically connected through the circuit board,
wherein each of the output parts comprises at least one terminal, and the terminal is arranged in the receiving cavity and passes through the housing to a surface of the housing;
a detection module, connected to the charging module for obtaining charging information, and the charging information at least comprising at least one of battery capacity information, charging real-time status information, and charging prediction information; and
a display module, an input end of the display module connected to an output end of the detection module, and the charging information of one or more connected devices to be charged being displayed through the display module.

18. A charging man-machine interaction display system, comprising:
a detection module, configured to obtain charging information, the charging information comprising at least one of battery capacity information, charging real-time status information, and charging prediction information; and
a display module, an input end of the display module being connected to an output end of the detection module, and the charging information of one or more connected devices to be charged being displayed through the display module.

19. A method of charging man-machine interaction, comprising:
obtaining charging information, the charging information comprising at least one of battery capacity information, charging real-time status information, and charging prediction information; and
displaying the charging information of one or more connected devices to be charged.

20. A method of intelligent allocation of charging power, comprising:
obtaining a working state of each load which is connected to multi-output port in a circuit for intelligent allocation of charging power;
determining at least one set of to-be-complementary output ports to be complemented by charging power according to the working state; and
controlling the set of to-be-complementary output ports to be complemented by charging power.

21. A method of charging energy distribution, comprising:
obtaining a charging state of one or more charged devices, each charged device being connected to a same circuit for charging energy distribution; and
if there is a target charged device, controlling the circuit for charging energy distribution to charge the target charged device with a maximum output charging power, and suspend charging of remaining charged devices, wherein the target charged device is one of the charged devices with a charging state reaching a preset charging state.
